# EUROPEAN PATENT APPLICATION

(11) **EP 2 259 306 A1**
(43) Date of publication of application: **08.12.2010**
(21) Application number: 09725762.0
(22) Date of filing: 23.03.2009
(51) Int. Cl.: H01L 21/8247, H01L 27/10, H01L 27/115, H01L 29/788, H01L 29/792

(54) **SEMICONDUCTOR MEMORY AND METHOD FOR MANUFACTURING THE SAME**

(30) Priority: 26.03.2008 JP 2008080543
(71) Applicant: Kabushiki Kaisha Toshiba, Minato-ku Tokyo 105-8001 (JP)
(72) Inventor: KIYOTOSHI, Masahiro, Tokyo 105-8001 (JP)
(74) Representative: HOFFMANN EITLE
(86) International application number: PCT/JP2009/055713
(87) International publication number: WO 2009/119527

(57) **Abstract**

A semiconductor memory capable of increasing bit density by three-dimensional arrangement of cells and a method for manufacturing the same are provided.

In a semiconductor memory 1, gate electrode films 21 are provided on a silicon substrate 11. The gate electrode films 21 are arranged in one direction parallel to the upper surface of the silicon substrate 11 (X direction). Each gate electrode film 21 has a lattice plate-like shape, having through holes 22 in a matrix form as viewed in the X direction. Silicon beams 23 are provided passing through the through holes 22 of the gate electrode films 21 and extending in the X direction. Further, an ONO film 24 including a charge storage layer is provided between the gate electrode film 21 and the silicon beam 23.

## Description

### Technical Field

This invention relates to a semiconductor memory and a method for manufacturing the same, and more particularly to a semiconductor memory including three-dimensionally arranged memory cells and a method for manufacturing the same.

### Background Art

Flash memories are widely used as high-capacity data storage in cellular phones, digital still cameras, USB (Universal Serial Bus) memories, silicon audio players and the like, and continuing to expand the market as the manufacturing cost per bit is reduced by rapid downscaling. Furthermore, novel applications have also been fast emerging, achieving a virtuous circle in which downscaling and manufacturing cost reduction find new markets.

In particular, a NAND flash memory allows a plurality of active areas (hereinafter also referred to as "AA") to share a gate conductor (hereinafter also referred to as "GC"), thereby substantially realizing cross-point cells having a cell area of 4F², where F is the minimum processing dimension, and is being rapidly downscaled because of its simple structure. Because of this reduction of cost per bit associated with downscaling, NAND flash memories have been widely used for storage applications such as the aforementioned USB memories and silicon audio players, and are expected to replace HDD (hard disk drive) and other main memories in the future. Hence, recently, NAND flash memories have led semiconductor microfabrication, and the minimum processing dimension has reached 70 nm or less even in volume production. Although technical difficulty has been rapidly growing with downscaling, there is a demand for fast downscaling also in the future, where the cell area is approximately halved every 1.5 years.

However, there are numerous problems to advance downscaling of flash memories also in the future. The problems are listed below.
(1) The development of lithography techniques cannot catch up with the rapid downscaling. Already in the current status, the market release of a lithography apparatus is immediately followed by the start of volume production. In the future, the lithography technique is required to continue increasing the bit density in status quo.
(2) Decreased device dimensions associated with downscaling cause the short channel effect and the narrow channel effect to sharply become pronounced, which has made it difficult generation by generation to ensure the reliability and fast operation of nonvolatile memories.
(3) From decreased device dimensions associated with downscaling, it is predicted that in the future, statistical fluctuation in the number of atoms, for example, deteriorates device characteristics, or variations in device characteristics.

Because of the foregoing problems (1) to (3), it is probably difficult to continue increasing the bit density in the future by means of simple downscaling in a horizontal plane alone.

In this context, a multilayer memory is under consideration as a structure of a semiconductor memory which can realize a higher bit density for memory elements without totally depending on downscaling in lithography techniques (see, e.g., Patent Document 1). Patent Document 1 discloses a method for successively stacking a plurality of memory layers. However, this technique is based on stacking the memory layers one layer by one layer. Hence, increase in the number of memory layers results in increasing the number of manufacturing steps, and also increasing manufacturing cost. Thus, this technique has a problem with manufacturing cost per bit.

To overcome these problems, a new multilayer flash memory is proposed (see Patent Document 2 and Non-Patent Document 1). In this memory, dielectric films and electrode films are alternately stacked on a substrate, and then through holes are simultaneously formed. A charge storage layer for retaining charge is formed on the side surface of this through hole, and a pillar-shaped electrode is filled inside the through hole. Thus, memory cells are three-dimensionally arranged at intersections between the pillar-shaped electrodes and the electrode films. Furthermore, a plurality of select gate lines extending in one direction are provided on the uppermost electrode film, and a plurality of bit lines extending in another direction are provided thereabove and connected to the upper end portion of the pillar-shaped electrodes, allowing an arbitrary pillar-shaped electrode to be selected. On the other hand, the electrode films are connected respectively to different word interconnects, allowing an arbitrary electrode film to be selected. Consequently, an arbitrary memory cell can be selected to write and read data.

In contrast to the aforementioned multilayer memory described in Patent Document 1, this technique includes only one lithography step for each fine component such as AA and GC independent of the number of stacked layers. Hence, advantageously, the manufacturing cost per bit decreases as the number of stacked layers increases. Furthermore, the cell transistor is an SGT (surrounding gate transistor), in which the gate electrode completely surrounds the pillar-shaped silicon channel. The SGT is characterized by its strong control over the channel, allowing the short channel effect to be reduced and being ready for multilevel operation.

However, to select an arbitrary one of channel silicon pillars arranged in an array, it is necessary to provide the select gates in a banded configuration in a plane.
Patent Document 1: JP-A-H07-235649
Patent Document 2: JP-A-2007-266143
Non-Patent Document 1: H. Tanaka, M. Kido, et al. "Bit Cost Scalable Technology with Punch and Plug Process for Ultra High Density Flash Memory" 2007 Symposium on VLSI Technology Digest of Technical Papers, p.14-15

### Disclosure of Invention

### Problems to be solved by the invention

An object of the invention is to provide a semiconductor memory capable of increasing bit density by three-dimensional arrangement of cells, and a method for manufacturing the same.

### Means for solving the problems

According to an aspect of the invention, there is provided a semiconductor memory including: a substrate; a plurality of gate electrode films provided on the substrate, arranged along one direction parallel to an upper surface of the substrate, and including a plurality of through holes as viewed in the one direction; a plurality of semiconductor beams extending in the one direction through the through holes of the plurality of gate electrode films; and a charge storage layer provided between the gate electrode film and the semiconductor beam.

According to another aspect of the invention, there is provided a method for manufacturing a semiconductor memory, including: forming a multilayer body by alternately stacking a plurality of dielectric films and semiconductor films on a substrate; dividing the multilayer body in a first direction parallel to an upper surface of the substrate to form a plurality of semiconductor beams made of the divided semiconductor films and extending in a second direction parallel to the upper surface of the substrate and orthogonal to the first direction; providing dielectric bodies between the divided multilayer bodies discontinuously in the second direction; performing etching through a gap surrounded by the divided multilayer bodies and the dielectric bodies to remove a portion of the dielectric films sandwiched between the gaps; forming a charge storage layer on an exposed surface of the semiconductor beams; and filling a conductive material in a space among remaining portions of the dielectric films, the dielectric bodies, and the semiconductor beams to form a gate electrode film.

According to another aspect of the invention, there is provided a method for manufacturing a semiconductor memory, including: forming a multilayer body by alternately epitaxially growing a plurality of silicon germanium films and silicon films on a substrate; dividing the multilayer body in a first direction parallel to an upper surface of the substrate to form a plurality of silicon beams made of the divided silicon films and extending in a second direction parallel to the upper surface of the substrate and orthogonal to the first direction; removing the silicon germanium films to expose the silicon beams; filling a dielectric bodies between the silicon beams; forming a plurality of trenches arranged in the second direction in a portion of the dielectric bodies between the silicon beams arranged in the first direction; removing a portion of the dielectric bodies sandwiched between the trenches and sandwiched between the vertically arranged silicon beams by performing etching through the trenches; forming a charge storage layer on an exposed surface of the silicon beams; and forming a gate electrode film by filling a conductive material in a space among remaining portions of the dielectric bodies and the silicon beams.

According to another aspect of the invention, there is provided a method for manufacturing a semiconductor memory, including: forming a first multilayer body by alternately epitaxially growing a plurality of silicon germanium films and silicon films on a substrate; removing the silicon germanium films; forming a second multilayer body with the silicon films and silicon thermal oxide films alternately stacked, by thermally oxidizing the silicon films to form the silicon thermal oxide film between the silicon films; dividing the second multilayer body in a first direction parallel to an upper surface of the substrate to form a plurality of silicon beams made of the divided silicon films and extending in a second direction parallel to the upper surface of the substrate and orthogonal to the first direction; providing dielectric bodies between the divided second multilayer bodies discontinuously in the second direction; performing etching through a gap surrounded by the divided second multilayer bodies and the dielectric bodies to remove a portion of the silicon thermal oxide films sandwiched between the gaps; forming a charge storage layer on an exposed surface of the silicon beams; and forming a gate electrode film by filling a conductive material in a space among remaining portions of the silicon thermal oxide films, the dielectric bodies, and the silicon beams.

### Effects of the invention

According to the invention, a semiconductor memory capable of increasing bit density by three-dimensional arrangement of cells, and a method for manufacturing the same can be realized.

### Brief description of the drawings

FIG. 1 is a cross-sectional view parallel to the extending direction of silicon beams illustrating a semiconductor memory according to a first embodiment of the invention.
FIG. 2 is a cross-sectional view perpendicular to the extending direction of silicon beams illustrating the semiconductor memory according the first embodiment.
FIG. 3 is a cross-sectional perspective view illustrating the inside of a memory region of the semiconductor memory according to the first embodiment.
FIG. 4 is a perspective view illustrating a gate electrode film and a silicon beam in the memory region of the semiconductor memory according to the first embodiment.
FIG. 5 is a cross-sectional view illustrating a basic unit of a structure body 25 in the first embodiment.
FIG. 6 is a perspective view illustrating one end portion of the memory region of the semiconductor memory according to the first embodiment.
FIG. 7 is a process cross-sectional view illustrating a method for manufacturing a semiconductor memory according to a comparative example.
FIG. 8 is a process cross-sectional view illustrating the method for manufacturing the semiconductor memory according to the comparative example.
FIG. 9 is a process cross-sectional view illustrating the method for manufacturing the semiconductor memory according to the comparative example.
FIG. 10 is a process cross-sectional view illustrating the method for manufacturing the semiconductor memory according to the comparative example.
FIG. 11 is a process cross-sectional view illustrating the method for manufacturing the semiconductor memory according to the comparative example.
FIG. 12 is a plan view illustrating the semiconductor memory according to the comparative example.
FIGS. 13A and 13B are process cross-sectional views illustrating a method for manufacturing a semiconductor memory according to a second embodiment of the invention, where FIG. 13A shows a YZ cross section and FIG. 13B shows an XZ cross section.
FIGS. 14A and 14B are process cross-sectional views illustrating the method for manufacturing the semiconductor memory according to the second embodiment, where FIG. 14A shows a YZ cross section and FIG. 14B shows an XZ cross section.
FIGS. 15A and 15B are process cross-sectional views illustrating the method for manufacturing the semiconductor memory according to the second embodiment, where FIG. 15A shows a YZ cross section and FIG. 15B shows an XZ cross section.
FIGS. 16A and 16B are process cross-sectional views illustrating the method for manufacturing the semiconductor memory according to the second embodiment, where FIG. 16A shows a YZ cross section and FIG. 16B shows an XZ cross section.
FIGS. 17A and 17B are process cross-sectional views illustrating the method for manufacturing the semiconductor memory according to the second embodiment, where FIG. 17A shows a YZ cross section and FIG. 17B shows an XZ cross section.
FIG. 18 is a perspective cross-sectional view illustrating the method for manufacturing the semiconductor memory according to the second embodiment.
FIG. 19 is a perspective cross-sectional view illustrating the method for manufacturing the semiconductor memory according to the second embodiment.
FIG. 20 is a perspective cross-sectional view illustrating the method for manufacturing the semiconductor memory according to the second embodiment.
FIG. 21 is a perspective cross-sectional view illustrating the method for manufacturing the semiconductor memory according to the second embodiment.
FIG. 22 is a process cross-sectional view illustrating a method for manufacturing a semiconductor memory according to a third embodiment of the invention.
FIG. 23 is a perspective cross-sectional view illustrating the method for manufacturing the semiconductor memory according to the third embodiment.
FIG. 24 is a perspective cross-sectional view illustrating the method for manufacturing the semiconductor memory according to the third embodiment.
FIG. 25 is a perspective cross-sectional view illustrating the method for manufacturing the semiconductor memory according to the third embodiment.
FIG. 26 is a perspective cross-sectional view illustrating the method for manufacturing the semiconductor memory according to the third embodiment.
FIG. 27 is a perspective cross-sectional view illustrating the method for manufacturing the semiconductor memory according to the third embodiment.
FIG. 28 is a process cross-sectional view illustrating a method for manufacturing a semiconductor memory according to a fourth embodiment of the invention.
FIG. 29 is a perspective cross-sectional view illustrating the method for manufacturing the semiconductor memory according to the fourth embodiment.
FIG. 30 is a perspective cross-sectional view illustrating the method for manufacturing the semiconductor memory according to the fourth embodiment.
FIG. 31 is a perspective cross-sectional view illustrating the method for manufacturing the semiconductor memory according to the fourth embodiment.
FIG. 32 is a perspective cross-sectional view illustrating the method for manufacturing the semiconductor memory according to the fourth embodiment.

### Description of reference numerals

- 1: semiconductor memory
- 11: silicon substrate
- 12: multilayer interconnect layer
- 13: transistor
- 14: STI
- 15: gate oxide film
- 16: gate electrode
- 17: contact plug
- 18: interconnect
- 19: via plug
- 20: interlayer dielectric film
- 21: gate electrode film
- 22: through hole
- 23: silicon beam
- 24: ONO film
- 24a: silicon oxide layer
- 24b: silicon nitride layer
- 24c: silicon oxide layer
- 25: structure body
- 26: silicon nitride film
- 31: silicon oxide film
- 33: gate electrode member
- 35: bit interconnect
- 37: transistor
- 37c: channel region
- 37d: drain region
- 37s: source region
- 101: silicon substrate
- 102: gate oxide film
- 103: polycrystalline silicon film
- 104: STI
- 108: silicon nitride film
- 110: TEOS/O₃ film
- 111: trench
- 121: multilayer body
- 122: conductive film
- 123: dielectric film
- 126: gap
- 201: silicon substrate
- 202: epi-SiGe film
- 203: epi-Si film
- 204: epi-SiGe film
- 205: silicon nitride film
- 206: multilayer body
- 208: SOG film
- 209: trench
- 210: gap
- 211: WN film
- 221: multilayer body
- 305: silicon nitride film
- 306: multilayer body
- 308: silicon thermal oxide film
- 309: multilayer body
- 311: TaN film
- 401: gate electrode film
- 403: ONO film
- 404: silicon plug
- 405: hard mask
- 405a: opening
- 407: silicon film
- 409: select gate electrode
- 411: silicon pillar
- F: minimum processing dimension
- Rc: peripheral circuit region
- Rm: memory region

### Best Mode for Carrying Out the Invention

Embodiments of the invention will now be described with reference to the drawings.

At the outset, a first embodiment of the invention is described.

This embodiment relates to a semiconductor memory, and more particularly to a nonvolatile semiconductor memory.

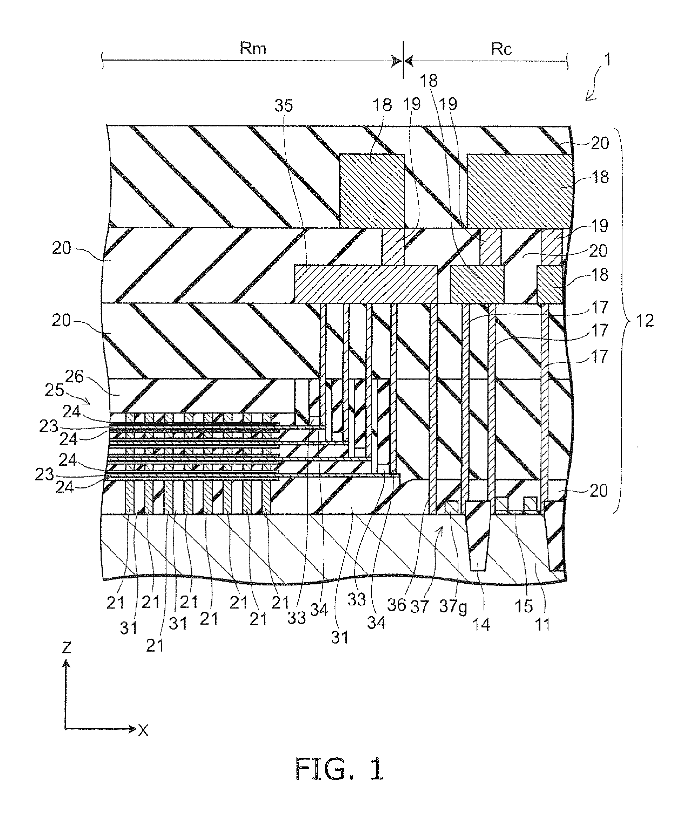

FIG. 1 is a cross-sectional view parallel to the extending direction of silicon beams illustrating the semiconductor memory according to this embodiment.

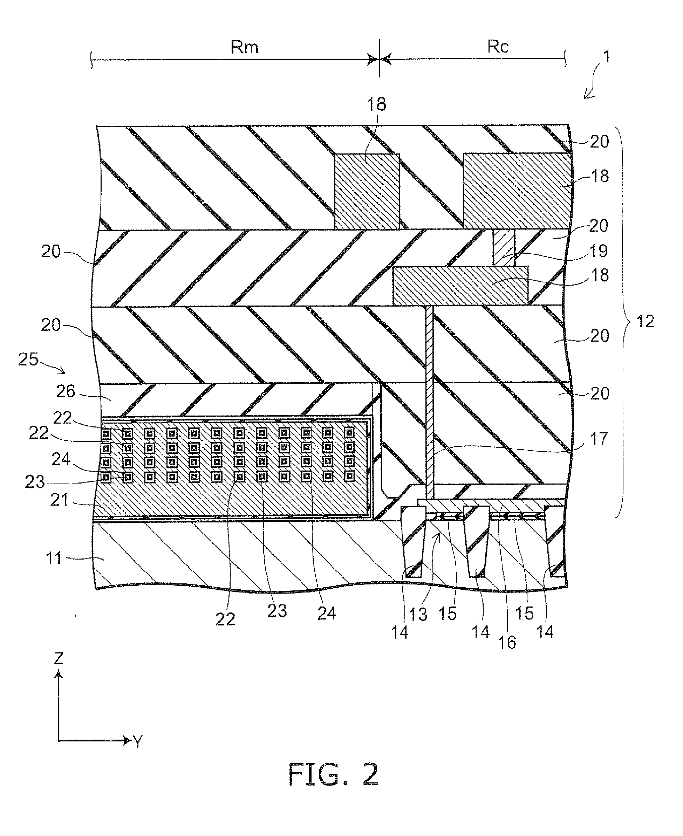

FIG. 2 is a cross-sectional view perpendicular to the extending direction of silicon beams illustrating the semiconductor memory according to this embodiment.

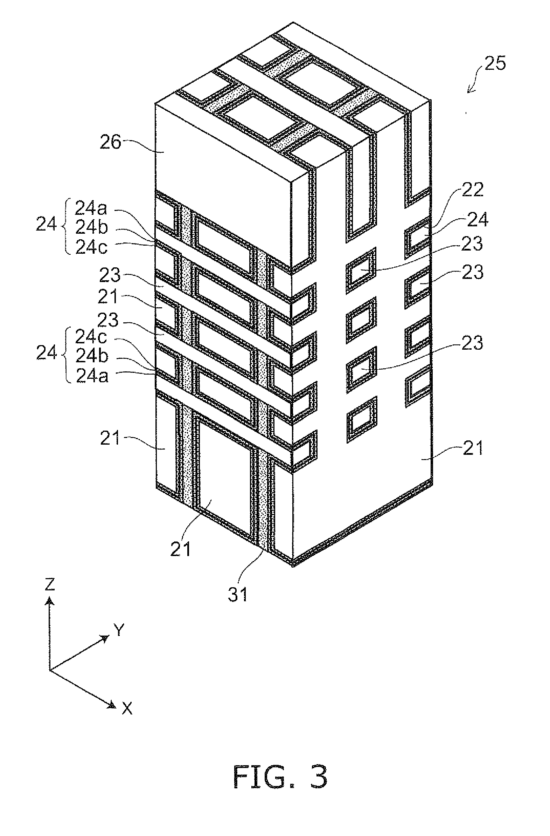

FIG. 3 is a cross-sectional perspective view illustrating the inside of the memory region of the semiconductor memory according to this embodiment.

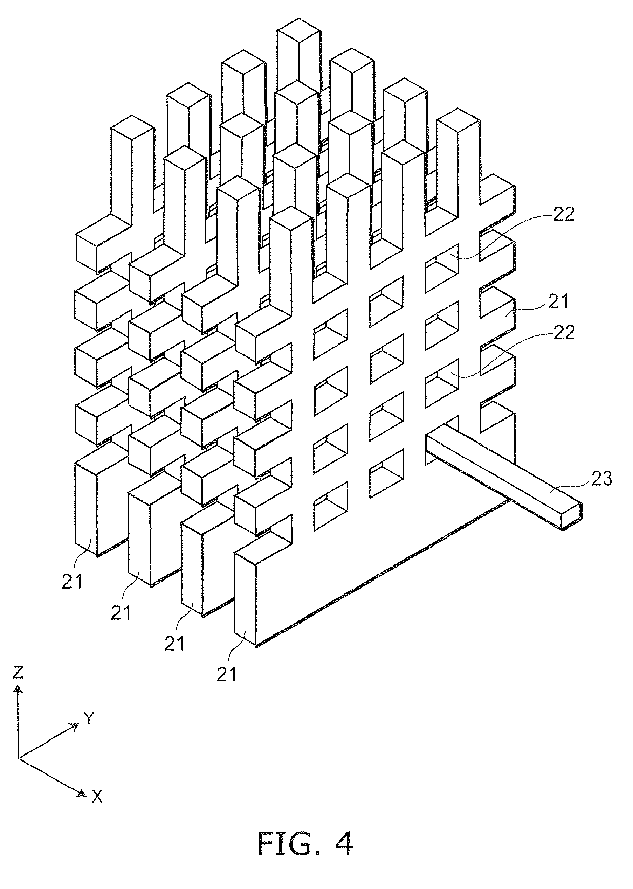

FIG. 4 is a perspective view illustrating the gate electrode film and the silicon beam in the memory region of the semiconductor memory according to this embodiment.

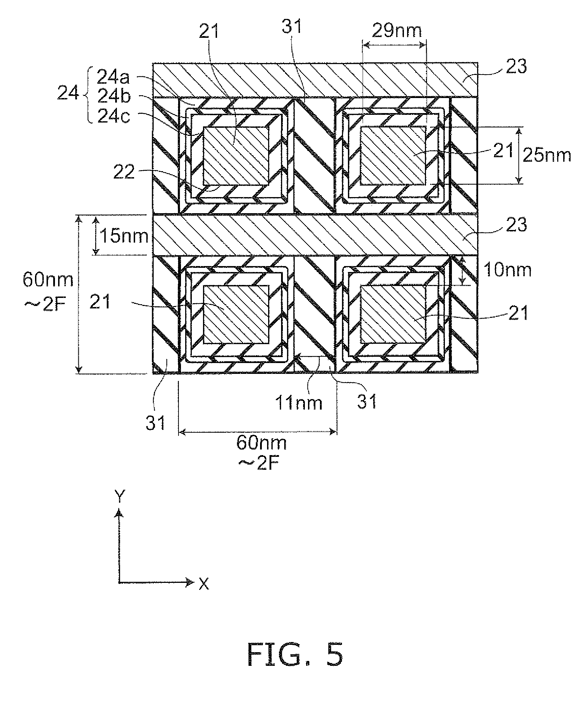

FIG. 5 is a cross-sectional view illustrating the basic unit of the structure body 25 in this embodiment.

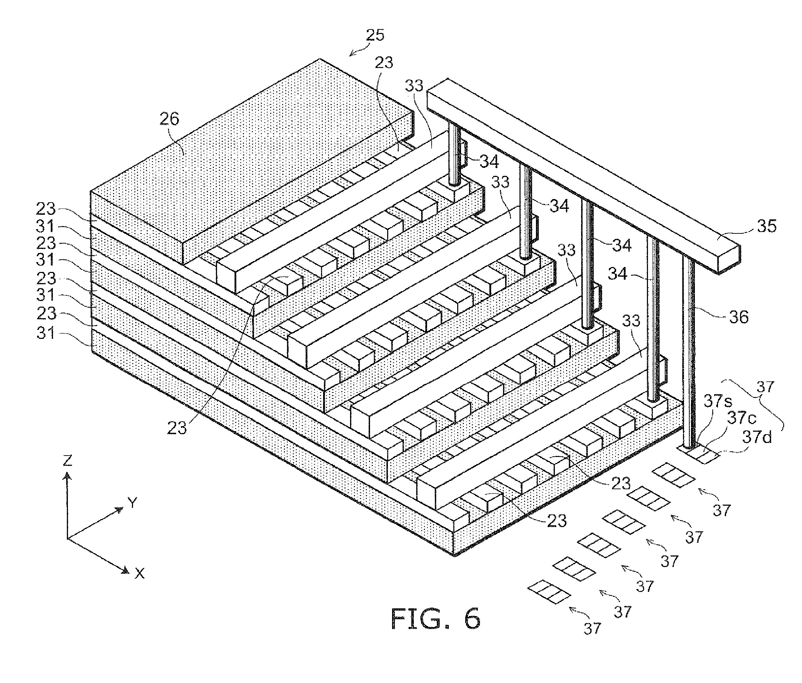

FIG. 6 is a perspective view illustrating one end portion of the memory region of the semiconductor memory according to this embodiment.

For clarity of illustration, in FIG. 4, components other than the gate electrode film and one silicon beam are not shown. In FIG. 6, the interlayer dielectric film is not shown.

As shown in FIGS. 1 and 2, the semiconductor memory 1 according to this embodiment includes a silicon substrate 11, and a multilayer interconnect layer 12 is provided on the silicon substrate 11. In the semiconductor memory 1, a memory region Rm including a plurality of memory cells for storing data, and a peripheral circuit region Rc including a driving circuit for driving the memory region Rm are defined.

The peripheral circuit region Rc illustratively includes a transistor 13 as part of the driving circuit for driving the memory region Rm. An STI (shallow trench isolation) 14 for isolating the transistor 13 from the surroundings is provided around the transistor 13 in the silicon substrate 11. The transistor 13 is formed from a source/drain region (not shown) formed in an upper portion of the silicon substrate 11, a gate oxide film 15 formed on the upper surface thereof, and a gate electrode 16 provided thereabove. Furthermore, the multilayer interconnect layer 12 in the peripheral circuit region Rc includes a contact plug 17 connected to the gate electrode 16 or the like of the transistor 13, an interconnect 18, and a via plug 19 for connecting between the vertically arranged interconnects 18, and these are filled in an interlayer dielectric film 20.

In this embodiment, for convenience of description, an XYZ orthogonal coordinate system is used. The direction perpendicular to the upper surface of the silicon substrate 11, that is, the vertical direction, is referred to as the Z direction, and the horizontal directions parallel to the upper surface of the silicon substrate 11, which are the two directions orthogonal to each other, are referred to as the X and Y directions. The same also applies to the other embodiments described later.

As shown in FIGS. 1 to 5, in the memory region Rm, a plurality of gate electrode films 21 are provided at the lowermost layer of the multilayer interconnect layer 12. As shown in FIGS. 3 and 4, each gate electrode film 21 is shaped like a plate spreading in the YZ plane, and as viewed in the X direction, it is shaped like a lattice with a plurality of through holes 22 arranged in a matrix. The plurality of gate electrode films 21 are equally spaced from each other in the X direction, and as viewed in the X direction, the positions of the through holes 22 formed in different gate electrode films 21 coincide with each other. The gate electrode film 21 is illustratively formed from polycrystalline silicon or a metal or an alloy, such as tungsten nitride (WN) or tantalum nitride (TaN). A silicon oxide film 31 is provided between the gate electrode films 21.

A silicon beam 23 shaped like a beam extending in the X direction is inserted through the through hole 22 of the gate electrode film 21. The silicon beam 23 is illustratively formed from polycrystalline silicon. In each gate electrode film 21, one silicon beam 23 is inserted through one through hole 22. Hence, the number of silicon beams 23 is equal to the number of through holes 22 formed in each gate electrode film 21, and the plurality of silicon beams 23 are arranged in a matrix in the YZ plane. Each silicon beam 23 is inserted through the through holes 22 of all the gate electrode films 21. In this embodiment, the number of silicon beams 23 arranged in the Z direction is illustratively four. However, the invention is not limited thereto.

As shown in FIG. 5, an ONO film (oxide-nitride-oxide film) 24 is provided between the gate electrode film 21 and the silicon beam 23. The ONO film 24 includes a silicon oxide layer 24a, a silicon nitride layer 24b, and a silicon oxide layer 24c stacked in this order from the silicon beam 23 side. The ONO film 24 is provided also between the silicon oxide film 31 and the gate electrode film 21.

The portion of the silicon beam 23 located inside the through hole 22 serves as an active area (AA), the gate electrode film 21 serves as a gate conductor (GC), and the silicon nitride layer 24b of the ONO film 24 serves as a charge storage layer. Thus, an SGT (surrounding gate transistor) is formed at each intersection between the gate electrode film 21 and the silicon beam 23 and serves as a memory cell. Consequently, in the structure body 25, a plurality of memory cells are arranged in a three-dimensional matrix along the X, Y, and Z directions.

As shown in FIGS. 1 and 2, the structure body 25 composed of a plurality of gate electrode films 21, a plurality of silicon beams 23, and the ONO films 24 is placed in a closed space in the semiconductor memory 1. Specifically, the structure body 25 is placed in a lower portion of the lowermost layer of the multilayer interconnect layer 12 in the memory region Rm. A silicon nitride film 26 is provided above the structure body 25 in the lowermost layer of the multilayer interconnect layer 12.

In FIG. 5, example dimensions of the components are shown. The portion between the openings 22 of the gate electrode film 21 has an X-direction length of 29 nm and a Y-direction length of 25 nm. The thickness of the ONO film 24 is 10 nm. The width of the silicon oxide film 31, that is, its X-direction length, is 11 nm. The width of the silicon beam 23, that is, its Y-direction length, is 15 nm. Hence, the X-direction and Y-direction lengths of the basic unit constituting the structure body 25 are both 60 nm.

On the other hand, as shown in FIG. 6, in one X-direction end portion of the structure body 25, the gate electrode film 21 and the ONO film 24 are not provided, but the silicon beam 23 is filled in the silicon oxide film 31. The structure body 25 is processed into a staircase pattern, and the number of stairs therein is equal to the number of silicon beams 23 arranged in the Z direction, that is, the number of floors. At each stair, at least the upper surface of the end portion of each silicon beam 23, illustratively the upper surface and both side surfaces, is located outside the silicon oxide film 31. The position of the X-direction end of the silicon beam 23 coincides with the stepped edge of the structure body 25. Thus, the X coordinates of the ends of a plurality of silicon beams 23 having an equal Z coordinate, that is, a plurality of silicon beams 23 provided on the same floor, are equal to each other.

A gate electrode member 33 extending in the Y direction is provided above each stair of the structure body 25 processed into a staircase pattern. Hence, the number of gate electrode members 33 is equal to the number of stairs of the structure body 25, that is, the number of silicon beams 23 arranged in the Z direction. Each gate electrode member 33 passes immediately above the end portions of a plurality of silicon beams 23 provided on each floor, that is, the portions located outside the silicon oxide film 31. A gate oxide film (not shown) is provided between these silicon beams 23 and the gate electrode member 33. The thickness of this gate oxide film is thick enough to insulate the gate electrode member 33 from the silicon beams 23, and thin enough to allow the potential of the gate electrode member 33 to affect the conduction state of these silicon beams 23. Thus, a field effect transistor is formed at the nearest point between the silicon beam 23 and the gate electrode member 33.

A via plug 34 is provided immediately above the end portion of each silicon beam 23, and a bit interconnect 35 extending in the X direction is provided immediately thereabove. The bit interconnect 35 is provided in the second interconnect layer of the multilayer interconnect layer 12, and the via plug 34 connects the silicon beam 23 to the bit interconnect 35. The bit interconnect 35 is provided for each column of silicon beams 23 arranged in the Z direction, and commonly connected to the silicon beams 23 belonging to each column, that is, a plurality of silicon beams 23 having an equal Y coordinate. Hence, the number of bit interconnects 35 is equal to the number of columns of silicon beams 23 in the Y direction. The bit interconnects 35 are arranged in the Y direction, and the arrangement pitch thereof is equal to the arrangement pitch of the silicon beams 23.

The bit interconnect 35 protrudes in the X direction from immediately above the structure body 25. A contact plug 36 is provided immediately below the protruding portion, and a transistor 37 is provided immediately therebelow. Thus, the bit interconnect 35 is connected to the source region 37s of the transistor 37 through the contact plug 36. In FIG. 5, for convenience of illustration, only one set of the via plugs 34, the bit interconnect 35, and the contact plug 36 is shown.

The source region 37s and the drain region 37d of the transistor 37 are formed in an upper portion of the silicon substrate 11 and arranged in the X direction. A channel region 37c is formed between the source region 37s and the drain region 37d, a gate dielectric film (not shown) is provided immediately thereabove, and a gate electrode 37g (see FIG. 1) is provided immediately thereabove. The number of transistors 37 provided is equal to the number of columns of silicon beams 23, and arranged obliquely along a direction between the X direction and the Y direction. The arrangement pitch of the transistors 37 in the Y direction is equal to the arrangement pitch of the silicon beams 23.

Next, the operation of the semiconductor memory 1 according to this embodiment is described.

In the semiconductor memory 1, the plurality of silicon beams 23 provided on one floor can be brought into conduction by setting the potential of one of the plurality of gate electrode members 33 to a potential such that the silicon beams 23 neighboring the one gate electrode member 33 are turned into the ON state. That is, by selecting one gate electrode member 33, one floor can be selected from the structure body 25, and the Z coordinate of a memory cell can be selected.

Furthermore, by turning one of the plurality of transistors 37 into the ON state and turning the other transistors 37 into the OFF state, one bit interconnect 35 can be selected, and the plurality of silicon beams 23 arranged in a line along the Z direction can be simultaneously selected. That is, by selecting one transistor 37, the Y coordinate of the memory cell can be selected.

Furthermore, by setting the potential of one of the plurality of gate electrode films 21 to be different from the potential of the other gate electrode films 21, in each silicon beam 23, the state of the portion located in the opening 22 of the one gate electrode film 21 can be made different from the state of the portion located in the opening 22 of the other gate electrode films 21. That is, by selecting one gate electrode film 21, the X coordinate of the memory cell can be selected.

Thus, one memory cell can be selected from a plurality of memory cells arranged in a three-dimensional matrix in the structure body 25. Then, data can be stored by storing charge in the silicon nitride layer 24b provided in this memory cell. Furthermore, data can be erased by extracting charge from the silicon nitride layer 24b. Moreover, the threshold voltage of the SGT constituting this memory cell depends on the presence or absence of charge in the silicon nitride layer 24b. Hence, by passing a sense current through the silicon beam 23 to which this memory cell belongs while bringing the memory cells on the silicon beam 23 other than this memory cell into "pass" state, it is possible to detect whether charge is stored in this memory cell, and to read data.

Next, the effect of this embodiment is described.

As shown in FIG. 5, in the X direction of the structure body 25 of the semiconductor memory 1, the gate electrode film 21 surrounded by the ONO film 24 and the silicon oxide film 31 are alternately arranged, and one gate electrode film 21 and one silicon oxide film 31 constitute a basic unit. A memory cell is configured for each such basic unit. As described later in detail in the second to fourth embodiments, this basic unit can be fabricated illustratively by etching the silicon oxide film 31. The ONO film 24 is formed by thermally oxidizing the surface of the silicon beam 23 and then depositing a silicon nitride layer and a silicon oxide layer, and thus requires no lithography processing. Hence, this basic unit can be configured with a length of 2F, where F is the minimum processing dimension.

On the other hand, in the Y direction of the structure body 25, the silicon beam 23 and the portion of the gate electrode film 21 surrounded by the ONO film 24 and located between the through holes 22 are alternately arranged, and one silicon beam 23 and one portion of the gate electrode film 21 constitute a basic unit. A memory cell is configured for each such basic unit. As described later in detail in the second to fourth embodiments, this basic unit can be fabricated illustratively by etching a multilayer body formed by alternately depositing silicon films and silicon oxide films on the silicon substrate 11. Hence, this basic unit can be configured with a length of 2F, where F is the minimum processing dimension.

Furthermore, as shown in FIG. 6, the gate electrode member 33 for selecting a floor of the structure body 25 is formed like a pillar extending in the Y direction, and hence is not constrained in processing accuracy in the Y direction. Furthermore, there need to be as many transistors 37 for selecting a column of silicon beams 23 in the Y direction as the silicon beams 23 arranged in the Y direction. However, because the source and the drain in the transistor 37 are arranged in the X direction, the arrangement pitch of the transistors 37 in the Y direction can be set to 2F. Furthermore, the transistors 37 can be shifted in the X direction as needed, and in this case, they are not constrained in processing accuracy in the Y direction.

Thus, the basic unit of the structure body 25 can be formed with an X-direction length of 2F and a Y-direction length of 2F, and the area of the basic unit in the XY plane can be set to 4F². Furthermore, because a memory cell is formed for each basic unit, the area per memory cell in the XY plane (cell area) is 4F². Consequently, the semiconductor memory 1 according to this embodiment can be downscaled in planar structure in the XY plane, and can achieve a bit density comparable to that of the conventional planar NAND flash memory. Furthermore, in the semiconductor memory 1 according to this embodiment, because the memory cells are arranged in the Z direction, the bit density of memory cells can be increased in proportion to the number of arrangement in the Z direction. Consequently, the bit density of memory cells can be increased without downscaling the planar structure beyond the limit of manufacturing technology.

Furthermore, the conventional planar NAND flash memory includes NAND chains, each composed of transistors of 32 cells or 64 cells connected in series. Here, data write and read are performed by first selecting one NAND chain, and then successively driving 32 or 64 gate electrodes in the selected NAND chain. Furthermore, in the planar NAND flash memory, this operation is assumed in designing the peripheral circuit. On the other hand, also in the semiconductor memory according to this embodiment, several ten or more memory cells can be formed in each silicon beam 23, and data write and read can be performed by selecting one silicon beam 23, and then successively driving the gate electrode films 21. That is, data write and read can be performed in a similar method to that of the conventional planar NAND flash memory. Thus, the semiconductor memory according to this embodiment can directly use the peripheral circuit of the conventional planar NAND flash memory.

Furthermore, in the semiconductor memory 1 according to this embodiment, the transistor constituting each memory cell has an SGT structure. Hence, it is resistant to the short channel effect. Furthermore, because the gate electrode film 21 has strong controllability over the channel, multilevel storage such as 2 bits/cell (= 4 levels) and 3 bits/cell (= 8 levels) is easily realized. Moreover, because the gate electrode film can completely surround the AA, it is possible to prevent interference with the adjacent cells, in which the threshold voltage of a cell is varied with write/erase operation on the adjacent cell.

Next, a comparative example of this embodiment is described.

This comparative example is an example of the techniques described in the Background Art section.

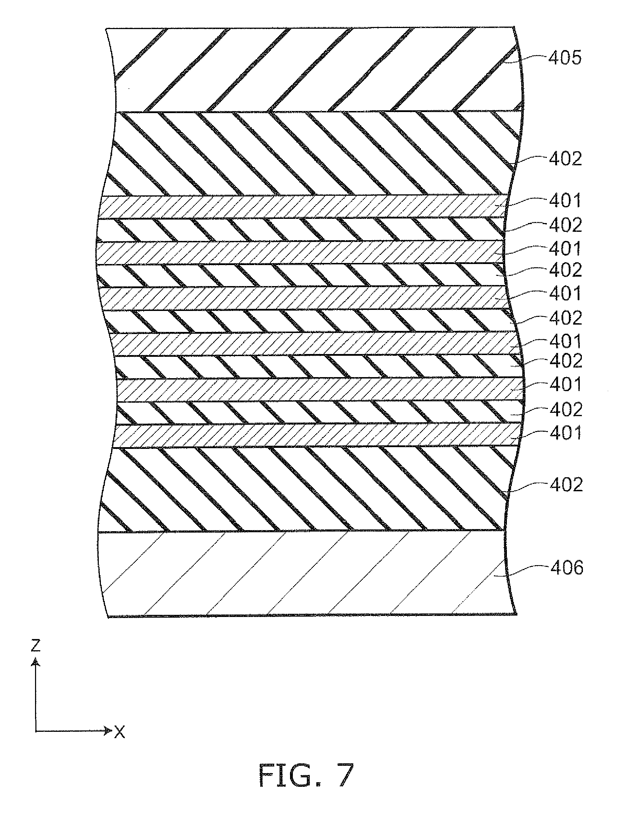

FIGS. 7 to 11 are process cross-sectional views illustrating a method for manufacturing a semiconductor memory according to this comparative example.

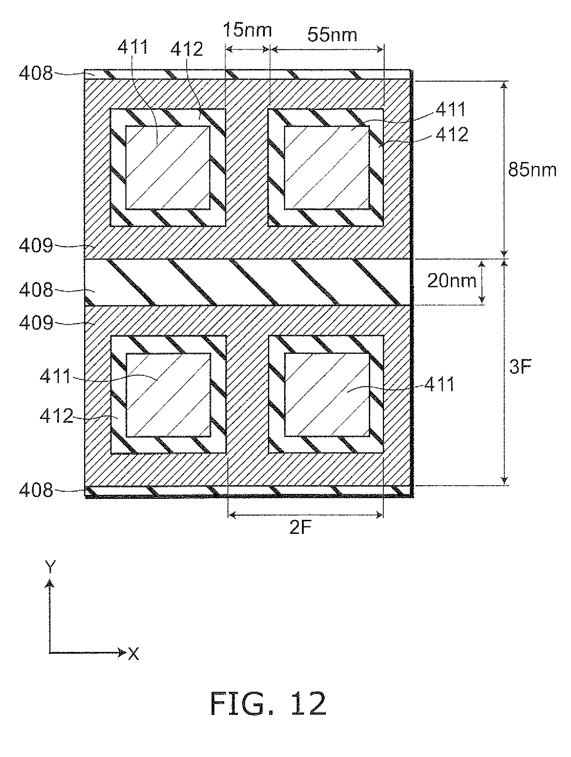

FIG. 12 is a plan view illustrating a semiconductor memory according to this comparative example.

Like the semiconductor memory according to the first embodiment, the semiconductor memory according to this comparative example includes a plurality of memory cells arranged in a three-dimensional matrix. However, this comparative example is different from the first embodiment in the spreading direction of the gate electrode film and the extending direction of the silicon beam. More specifically, in the semiconductor memory according to the first embodiment, each gate electrode film spreads perpendicular to the upper surface of the silicon substrate, and the silicon beam extends parallel to the upper surface of the silicon substrate. In contrast, in the semiconductor memory according to this comparative example, the gate electrode film spreads parallel to the upper surface of the silicon substrate, and a channel silicon (hereinafter, in this comparative example, referred to as "silicon pillar") extends perpendicular to the upper surface of the silicon substrate.

In the following, the method for manufacturing a semiconductor memory according to this comparative example is briefly described.

First, as shown in FIG. 7, dielectric films 402 made of silicon oxide and gate electrode films 401 made of polycrystalline silicon are alternately stacked on a silicon substrate 406, and a hard mask 405 is formed thereon.

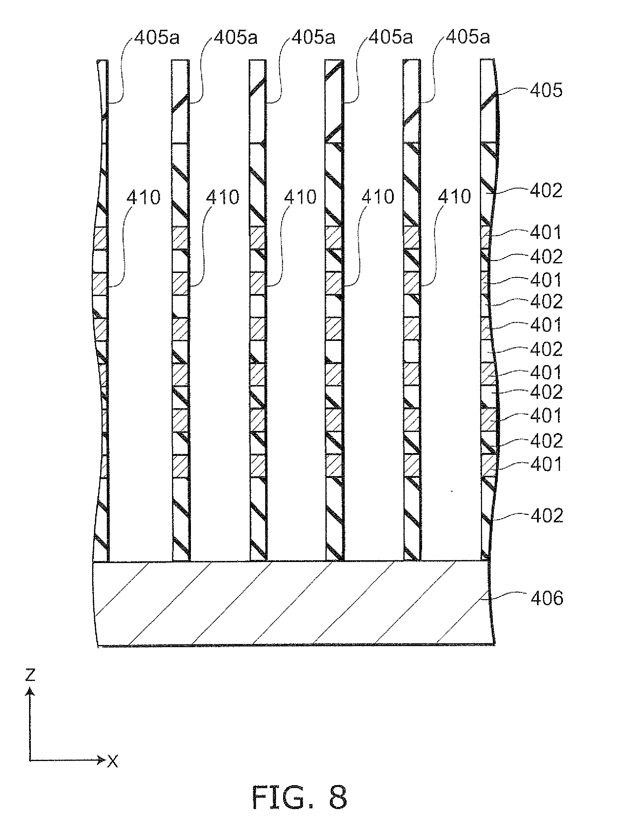

Next, as shown in FIG. 8, the hard mask 405 is patterned to form a plurality of openings 405a in a matrix configuration as viewed in the Z direction. Then, the patterned hard mask 405 is used as a mask to perform RIE (reactive ion etching) or other etching on the dielectric films 402 and the gate electrode films 401 so that through holes 410 reaching the silicon substrate 406 are formed in the multilayer body of the dielectric films 402 and the gate electrode films 401.

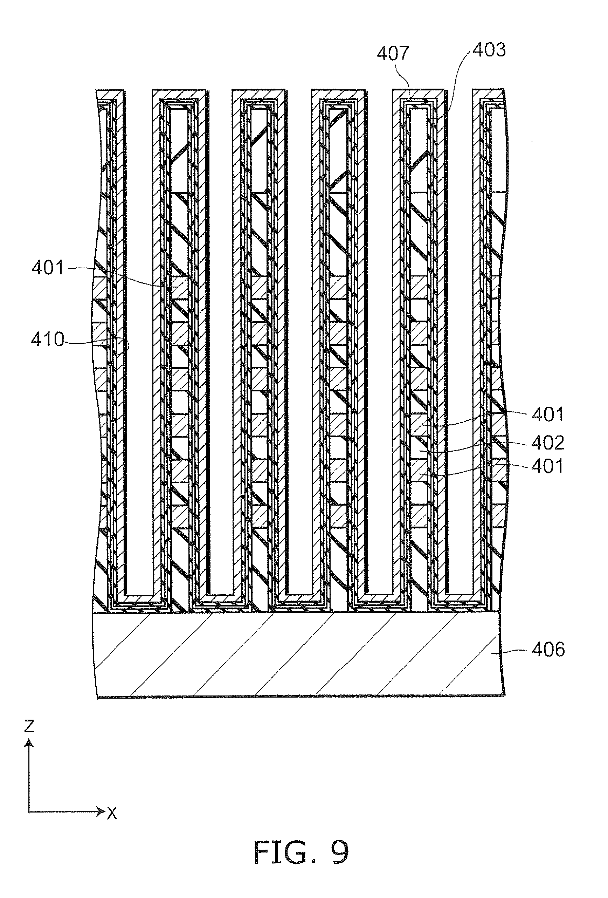

Next, as shown in FIG. 9, an ONO film 403 is formed on the inner surface of the through hole 410 using a conformal deposition such as CVD (chemical vapor deposition) or ALD (atomic layer deposition). The silicon nitride layer in the ONO film 403 formed on the side surface of the through hole 410 serves as a charge storage layer. Subsequently, the ONO film 403 provided on the bottom surface of the through hole 410 is removed. However, if RIE is performed while the ONO film 403 provided on the side surface of the through hole 410 is exposed, the ONO film 403 serving as a charge storage layer is damaged. Hence, the inner surface of the through hole 410 is once entirely covered with a silicon film 407 for protection.

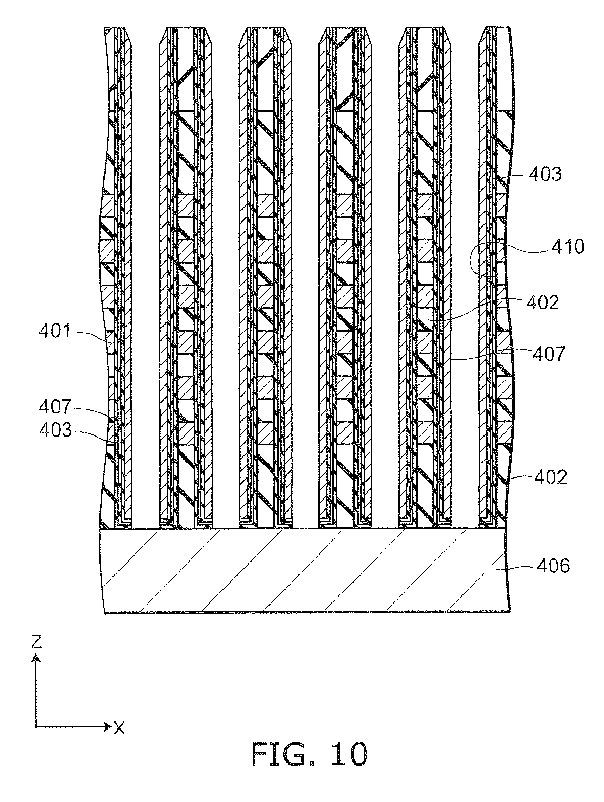

Then, as shown in FIG. 10, RIE is performed to remove the silicon film 407 and the ONO film 403 formed on the bottom surface of the through hole 410.

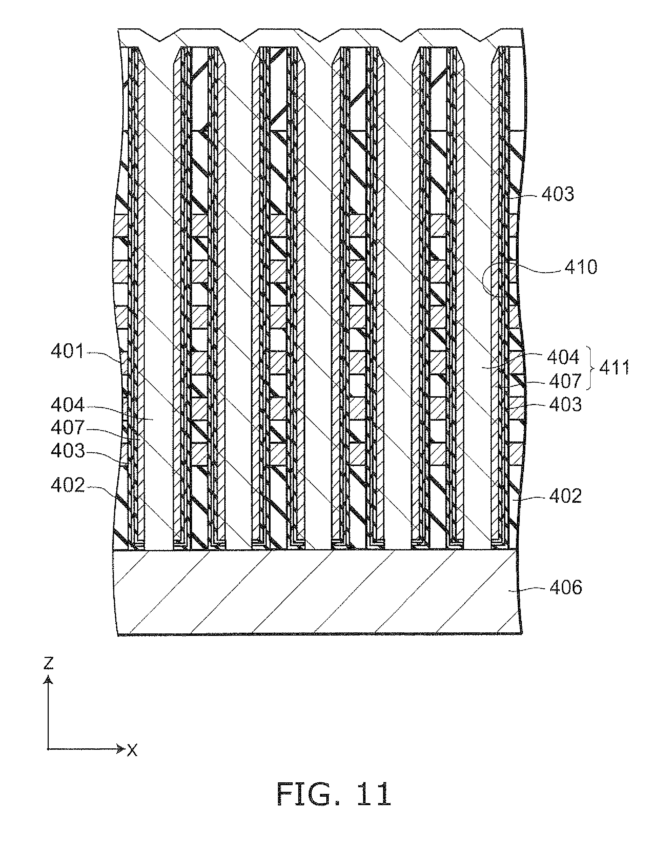

Next, as shown in FIG. 11, polycrystalline silicon is filled inside the through hole 410 to produce a silicon plug 404 connected to the silicon substrate 406. The silicon plug 404 and the silicon film 407 therearound constitute a silicon pillar 411. The silicon pillars 411 are arranged in a matrix in the XY plane.

Subsequently, as shown in FIG. 12, one polycrystalline silicon film is formed on the multilayer body of the dielectric films 402 and the gate electrode films 401, and processed by the lithography technique to form a plurality of select gate electrodes 409. Each select gate electrode 409 is shaped like a stripe extending in one of the arrangement directions of the silicon pillars 411, e.g., the X direction. That is, the plurality of select gate electrodes 409 are parallel spaced from each other at an equal height. Here, a dielectric film 408 is provided between the select gate electrodes 409 to insulate the select gate electrodes 409 from each other.

Next, a through hole penetrating through the select gate electrode 409 and communicating with the through hole 410 is formed, and a silicon oxide film 412 is formed on the inner surface of this through hole. Next, the silicon oxide film 412 formed on the bottom surface of the through hole is removed to expose the upper end surface of the silicon pillar 411, and then polycrystalline silicon is filled in the through hole. Thus, the newly filled polycrystalline silicon constitutes part of the silicon pillar 411. Furthermore, a plurality of bit interconnects (not shown) extending in the Y direction are provided above the select gate electrodes 409. Each bit interconnect is connected to the silicon pillars 411 arranged in a line along the Y direction.

Thus, an SGT is configured, in which the select gate electrode 409 serves as a gate electrode, the silicon oxide film 412 serves as a gate dielectric film, and the portion of the silicon pillar 411 surrounded by the select gate electrode 409 serves as a channel region. Consequently, by controlling the potential of an arbitrary select gate electrode 409, the "pass" state of the plurality of silicon pillars 411 arranged in a line in the X direction can be switched between the ON state and the OFF state.

As shown in FIGS. 11 and 12, in the X direction of such a semiconductor memory, the through hole 410 can be simply formed in the multilayer body of the dielectric films 402 and the gate electrode films 401. Hence, the dimension of the basic unit can be set to 2F, where F is the minimum processing dimension. Here, although the bit interconnects are also arranged in the X direction, each bit interconnect only needs to be connected to each silicon pillar 411, and does not need to surround the silicon oxide film 412. Hence, the bit interconnects can also be formed with a pitch of 2F.

However, in the Y direction, the select gate electrodes 409 need to be insulated from each other, and a through hole needs to be formed in each select gate electrode 409. Thus, the length of the basic unit is 3F. That is, schematically, the width of the through hole can be set to F, but the select gate electrode 409 requires a width of 2F, because the through hole is located in the select gate electrode 409. Furthermore, for insulation between the select gate electrodes 409, it is necessary to provide a dielectric film 408 between the select gate electrodes 409, which requires a width of at least F. Consequently, the area of the basic unit in the XY plane is 2F x 3F = 6F².

By way of example, the ONO film 403 and the silicon oxide film 42 require a thickness of 10 nm or more, and the silicon film 407 for protecting the ONO film 403 also requires a thickness of 10 nm or more. Furthermore, from the necessity of ensuring the amount of current and alignment with the silicon substrate 406, the silicon plug 404 requires a width of 15 nm or more. Hence, the through hole 410 has a width of 55 nm or more. Furthermore, in consideration of misalignment, the distance between the through holes 410 requires 15 nm or more, and the distance from the through hole 410 to the edge of the select gate electrode 409 as viewed in the Z direction also requires 15 nm or more. Moreover, to prevent dielectric breakdown, the dielectric film 408 requires a width of 20 nm or more. Hence, as for the size of the basic unit of the multilayer body, the minimum length in the X direction is 70 nm {= 10 (ONO film thickness) + 10 (silicon film thickness) + 15 (silicon pillar diameter) + 10 (silicon film thickness) + 10 [ONO film thickness] + 15 (minimum distance between through holes)}, and the minimum length in the Y direction is 105 nm {= 15 + 10 + 10 + 15 + 10 + 10 + 15 + 20 (minimum distance between select gate electrodes)}. Thus, the area of the basic unit is approximately 70 x 105 = 7350 nm².

In contrast, as described above, in the semiconductor memory 1 according to the first embodiment, the X-direction and Y-direction lengths of the basic unit constituting the multilayer body 25 are both 2F, and hence its area is 4F². This is the same as that of the conventional planar NAND flash memory. Thus, in contrast to the comparative example, the first embodiment can reduce the effective cell area by at least 2/3 for an equal number of stacked layers, or reduce the number of stacked layers by at least 2/3 for an equal effective cell area. The yield of the multilayer structure is the product of the yields of the layers therein. Hence, the first embodiment can achieve higher yield.

Furthermore, in the first embodiment, in contrast to the comparative example, the silicon beam is formed before the ONO film formation. Hence, there is no need to provide a silicon film 407 for protecting the ONO film. Thus, the basic unit in the XY plane can be further downscaled.

For example, as described above, in the first embodiment, the X-direction and Y-direction lengths of the basic unit are both 60 nm, and hence its area in the XY plane is 3600 nm². This area is approximately 55% with reference (100%) to the area of the basic unit in this comparative example (7350 nm²). Furthermore, if the number of stacked layers in the first embodiment is four, the effective cell area is 3600/4 = 900 nm². To realize an effective cell area equivalent thereto, the comparative example requires 8.17 layers, that is, more than twice the number of stacked layers.

In contrast, as described above, in the semiconductor memory 1 according to the first embodiment, because the silicon beam 23 extends parallel to the upper surface of the substrate, it is easy to form a long silicon beam 23, and easy to provide several ten or more memory cells in one silicon beam 23. Hence, the peripheral circuit of the conventional planar NAND flash memory can be used. Furthermore, the first embodiment includes fewer bit interconnects 35 than the comparative example. Thus, the number of sense circuits can be decreased, and the area of the semiconductor memory 1 can be reduced. Here, the number of gate electrode films 21 is increased. However, the gate electrode films 21 are connected to a power supply, and hence increase in the number thereof does not result in substantially increasing the area of the semiconductor memory 1.

Next, a second embodiment of the invention is described.

This embodiment relates to a first method for manufacturing the semiconductor memory according to the above first embodiment. This embodiment illustratively manufactures a 4-layer multilayer memory realizing a cell area of 900 nm², which corresponds to the 1X nm generation in the conventional planar NAND flash memory. In this embodiment, the silicon beam constituting active areas (AA) is formed from polycrystalline silicon.

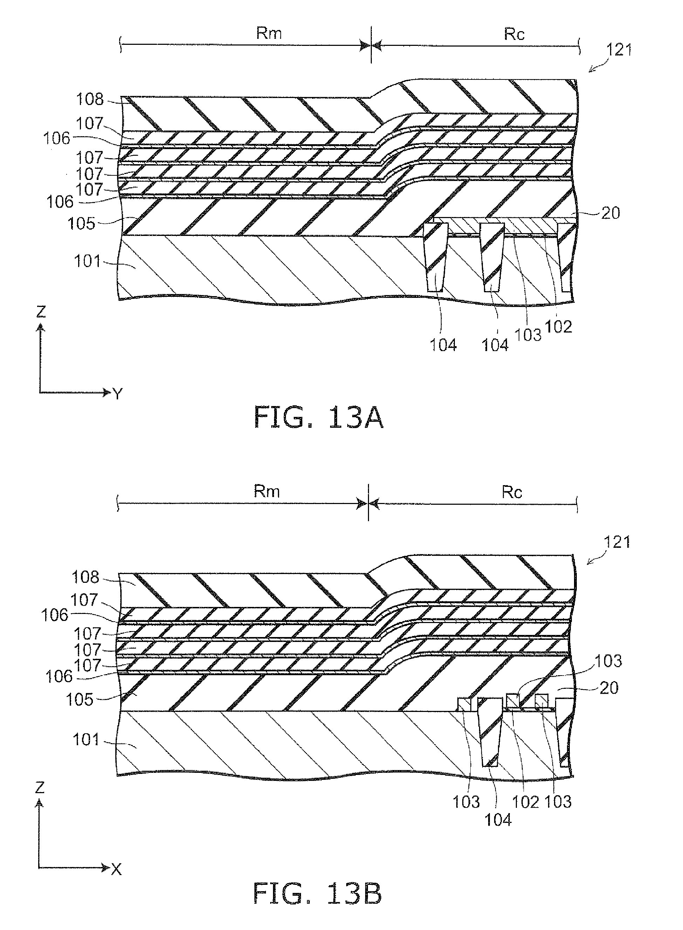

FIGS. 13A and 13B, 14A and 14B, 15A and 15B, 16A and 16B, and 17A and 17B are process cross-sectional views illustrating the method for manufacturing a semiconductor memory according to this embodiment, where FIGS. 13A, 14A, 15A, 16A, and 17A show the YZ cross section, and FIGS. 13B, 14B, 15B, 16B, and 17B show the XZ cross section.

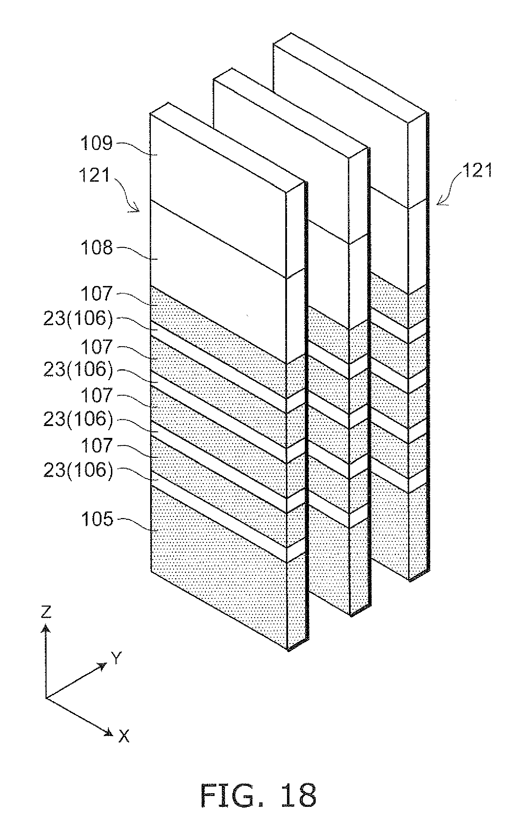

FIGS. 18 to 21 are perspective cross-sectional views illustrating the method for manufacturing a semiconductor memory according to this embodiment.

First, as shown in FIGS. 13A and 13B, in the peripheral circuit region Rc, a transistor constituting a driving circuit is formed. For example, the gate oxide film 102 of the transistor is formed on a silicon substrate 101, and an n-type polycrystalline silicon film 103 serving as the gate electrode of the transistor is formed. Furthermore, for isolation between the transistors, an STI (shallow trench isolation) 104 is formed. Some of the transistors thus formed are the transistors 13 and 37 shown in FIGS. 1, 2, and 6. The silicon substrate 101 corresponds to the silicon substrate 11 shown in FIG. 1 and other figures.

Next, a silicon oxide film 105 serving as an interlayer dielectric film is formed to a thickness of e.g. 200 nm entirely on the silicon substrate 101. Next, polycrystalline silicon films 106 having a thickness of 20 nm and silicon oxide films 107 having a thickness of e.g. 40 nm are alternately stacked, illustratively four layers each. The conductivity type of the polycrystalline silicon film 106 is illustratively n-type. Next, a silicon nitride film 108 is formed to a thickness of e.g. 100 nm. Thus, a multilayer body 121 is formed, which is composed of the silicon oxide film 105, the four polycrystalline silicon films 106, the four silicon oxide films 107, and the silicon nitride film 108.

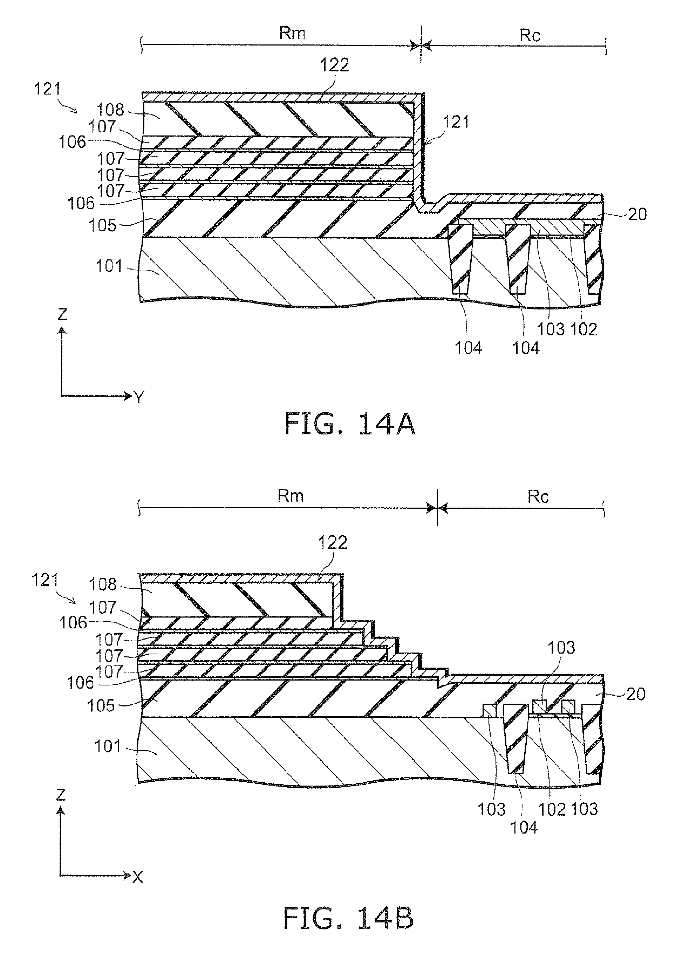

Next, as shown in FIGS. 14A and 14B, the known lithography technique and reactive ion etching (RIE) technique are used to remove the silicon nitride film 108, the silicon oxide films 107, and the polycrystalline silicon films 106 from the peripheral circuit region Rc. Here, in the neighborhood of the boundary between the memory region Rm and the peripheral circuit region Rc, the multilayer body 121 is processed into a staircase pattern in the XZ plane. That is, to expose the X-direction end portion of each polycrystalline silicon film 106, the films thereabove are removed.

Next, the X-direction end portion of each polycrystalline silicon film 106 is divided in the Y direction to form a plurality of beam-like portions. Then, at least the upper surface of the end portion of the polycrystalline silicon film 106 divided into beam-like portions is exposed. Next, a gate oxide film (not shown) is formed on the entire surface so as to cover the multilayer body 121 processed into a staircase pattern, and subsequently, a conductive film 122 is formed on the entire surface.

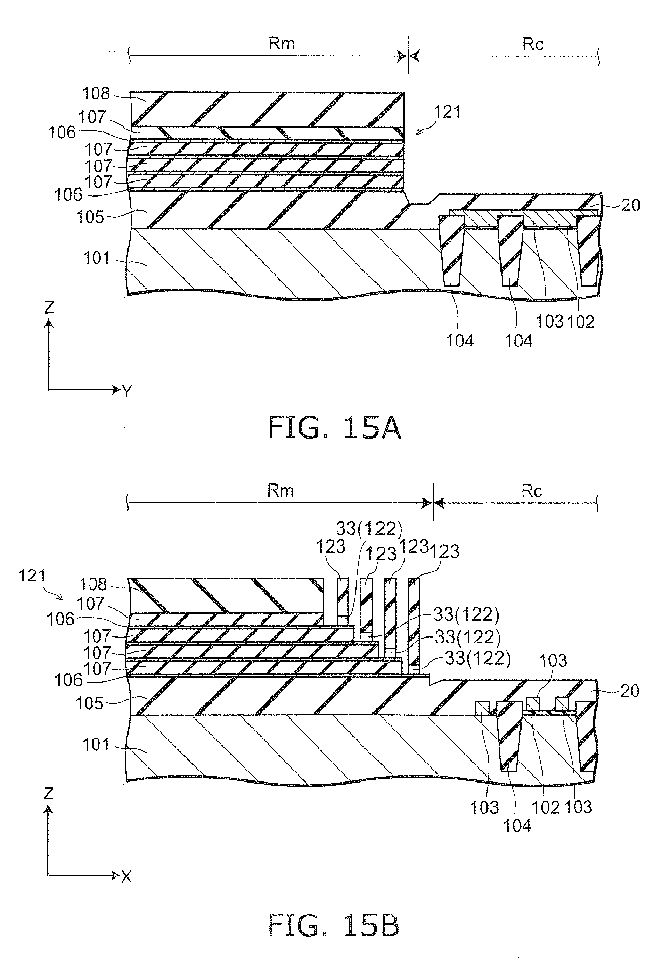

Next, as shown in FIGS. 15A and 15B, a dielectric film 123 is formed entirely on the silicon substrate 101, and planarized by CMP (chemical mechanical polishing). Next, the known lithography technique and reactive ion etching technique are used to selectively remove the dielectric film 123 so that it is left only on a strip-like region extending in the Y direction on the exposed portion of each polycrystalline silicon film 106. Next, the dielectric film 123 thus processed is used as a hard mask to etch the conductive film 122. Thus, the conductive film 122 is processed into a stripe traversing immediately above the exposed portion of each polycrystalline silicon film 106 and extending in the Y direction. Thus, a gate electrode member 33 made of polycrystalline silicon is formed. As described in the first embodiment, this gate electrode member 33 serves to select a floor of the multilayer body 121. Next, the known ion implantation, annealing and other techniques are used to form a diffusion layer in the end portion of the polycrystalline silicon film 106.

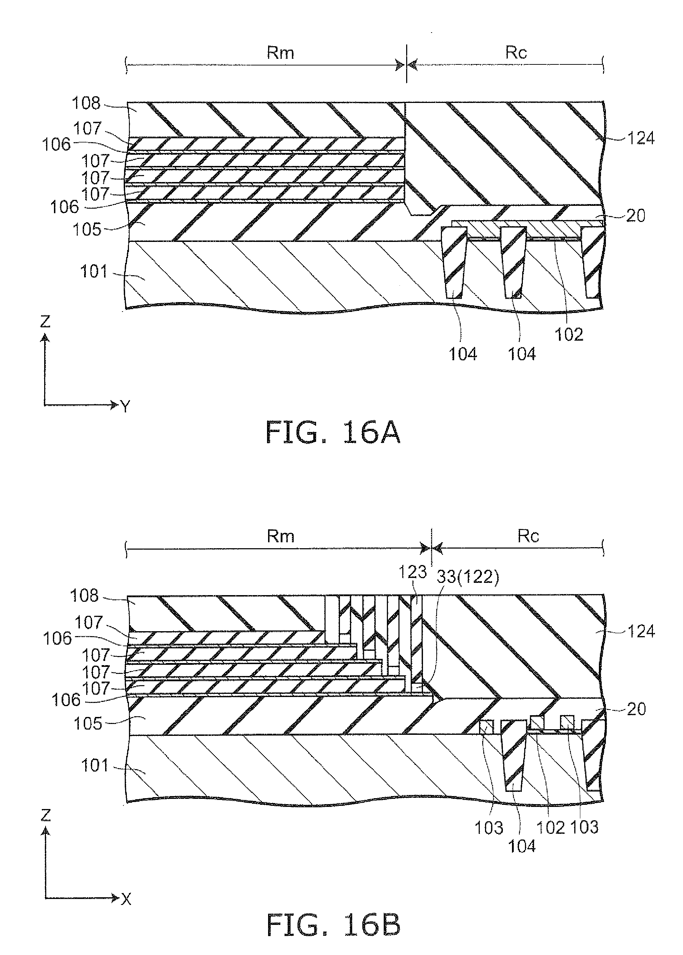

Next, as shown in FIGS. 16A and 16B, a dielectric film 124 is formed entirely on the silicon substrate 101, and planarized.

In the process shown in FIGS. 14A and 14B, in addition to the upper surface of the polycrystalline silicon film 106 divided into beam-like portions, preferably, its side surfaces are also exposed. Then, in the process shown in FIGS. 15A and 15B, the gate electrode member 33 can be formed so as to cover three surfaces of the polycrystalline silicon film 106 divided into beam-like portions. This improves the cut-off characteristics of the transistor composed of the end portion of the polycrystalline silicon film 106 and the gate electrode member 33.

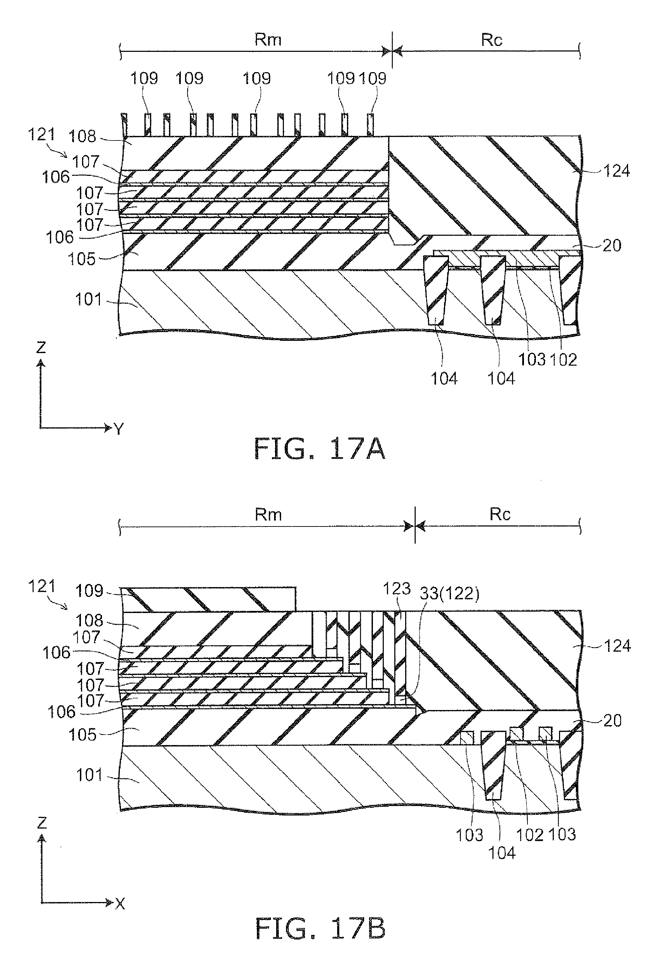

Next, as shown in FIGS. 17A and 17B, by CVD, a carbon film (not shown, hereinafter referred to as "CVD-C film") is formed entirely on the multilayer body 121, and processed by the conventional ArF lithography technique and RIE technique into a pattern of a plurality of stripes (not shown) extending in the X direction. Here, for example, these CVD-C films have an arrangement pitch of 120 nm and a width of 45 nm in the Y direction. Next, by low-temperature CVD, a silicon oxide film 109 is formed to a thickness of e.g. 15 nm so as to cover these CVD-C films. Subsequently, RIE is performed to form a sidewall, leaving the silicon oxide film 109 only on the side surface of the CVD-C film. Then, the CVD-C film is removed by ashing. Here, the sidewall made of the silicon oxide film 109 is left. Thus, a hard mask is formed, which is shaped like stripes extending in the X direction and has an arrangement pitch of 60 nm and a width of 15 nm in the Y direction.

Next, as shown in FIG. 18, the silicon oxide film 109 is used as a hard mask to perform etching so that the multilayer body 121 is simultaneously processed into a banded pattern. Thus, the multilayer body 121 is divided in the Y direction into a plurality of plate-like portions spreading in the XZ direction. The thickness of each plate-like portion, that is, its length in the Y direction, is equal to the width of the silicon oxide film 109, e.g. 15 nm, and the distance between the plate-like portions is e.g. 45 nm. Here, the polycrystalline silicon films 106 are also divided in the Y direction into a plurality of silicon beams 23 extending in the X direction. That is, in each plate-like portion, a plurality of silicon beams 23 are formed, which are made of the divided polycrystalline silicon films 106, extend in the X direction, and are arranged in the Z direction. The XY cross section of each silicon beam 23 is shaped like a rectangle having a Y-direction length of e.g. 15 nm and a Z-direction length of e.g. 20 nm. Here, each beam-like portion formed by dividing the end portion of the polycrystalline silicon film 106 in the process shown in FIG. 14 is connected with the corresponding silicon beam 23.

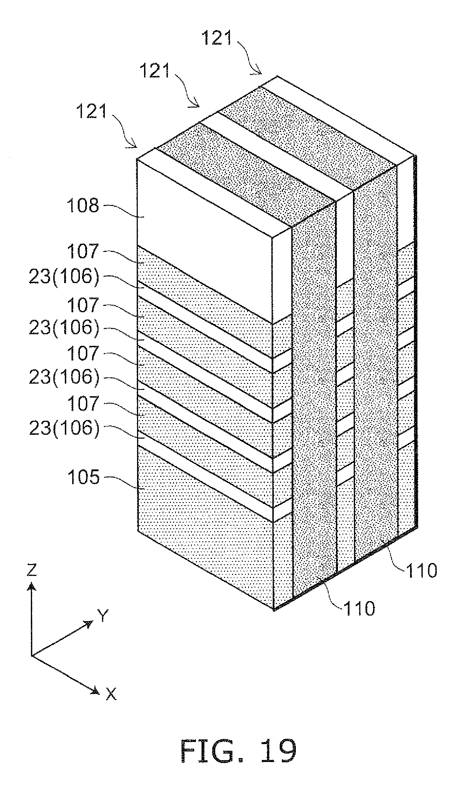

Next, as shown in FIG. 19, a dielectric body, TEOS (tetraethoxysilane, Si(OC₂H₅)₄) /O₃ film 110, is filled between the multilayer bodies 121 divided into a banded pattern, and the upper surface is planarized by CMP.

Next, the ArF lithography technique and RIE technique are used to form a pattern of a CVD-C film on the multilayer body 121 and the TEOS/O₃ film 110. This pattern is made of a plurality of stripes extending in the Y direction and having an arrangement pitch of 120 nm and a width of 15 nm in the X direction. Next, a sidewall made of a silicon oxide film is formed on the side surface of this CVD-C film and thereby integrated with the CVD-C film to form a pattern of a plurality of stripes extending in the Y direction and having an arrangement pitch of 60 nm and a width of 45 nm in the X direction.

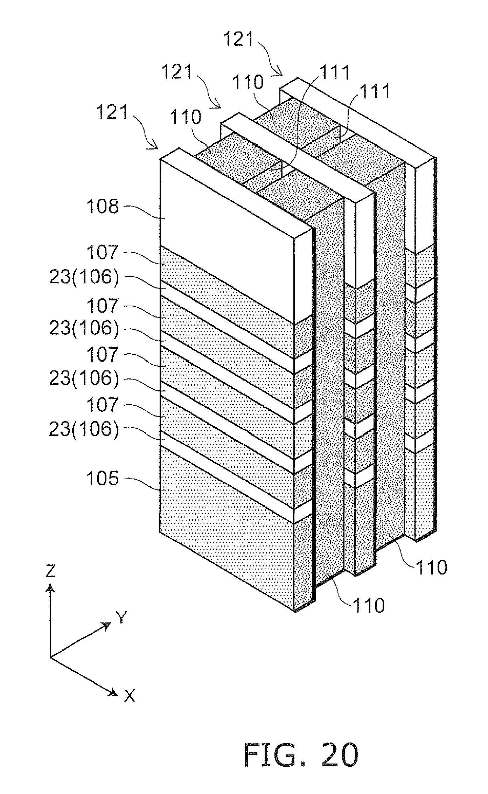

Next, as shown in FIG. 20, this pattern is used as a hard mask to perform conventional RIE to form trenches 111 in the TEOS/O₃ film 110 discontinuously in the X direction. The trench 111 is caused to reach the silicon substrate 101. Here, because the multilayer bodies 121 are not removed, the trench 111 is formed only in the region between the multilayer bodies 121 divided in the Y direction to constitute a gap surrounded by the divided multilayer bodies 121 and the TEOS/O₃ film 110. In other words, TEOS/O₃ films 110, as the dielectric bodies, are formed discontinuously in the X direction between the multilayer bodies 121 divided in the Y direction. Hence, as viewed in the Z direction, the trenches 111 are arranged in a matrix. Each trench 111 is shaped like a rectangle having an X-direction length of 15 nm and a Y-direction length of 45 nm. Here, of the X-direction end portions of the multilayer body 121, no trench 111 is formed in the end portion where the gate electrode member 33 is formed.

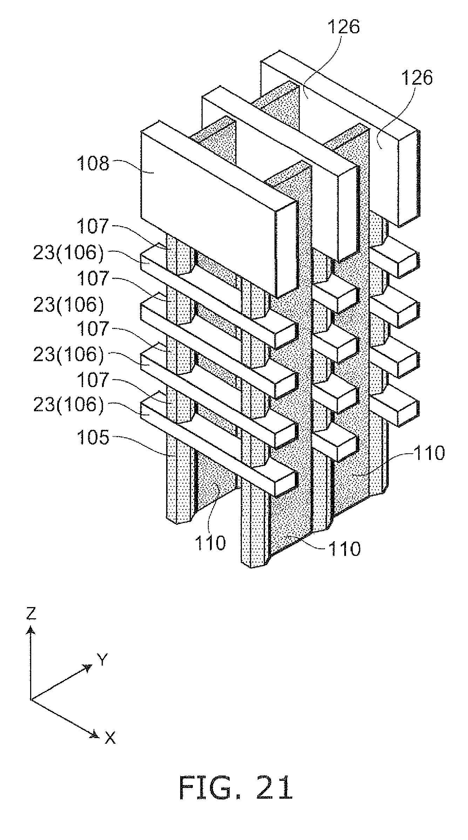

Next, as shown in FIG. 21, wet etching is performed. Thus, through the trenches 111, the TEOS/O₃ film 110 is removed from both sides. However, the TEOS/O₃ film 110 is not completely removed. For example, the TEOS/O₃ film 110, having a thickness (X-direction length) of 45 nm before etching, is etched by 17 nm from both sides, and the remaining portion has a thickness of 11 nm.

On the other hand, at this time, the portion of the silicon oxide film 107 sandwiched between the trenches 111 is also etched from both sides. For example, if the silicon oxide film 107 has a thickness (Y-direction length) of 15 nm before etching, it is etched from both sides by as much as 10 nm each. Thus, this portion is completely removed, and a through hole is formed. However, the portion of the silicon oxide film 107 sandwiched between the TEOS/O₃ films 110 is left.

Consequently, the trenches 111 arranged in the Y direction all communicate with each other to form a single gap 126 spreading in the YZ plane. In the gap 126, the silicon beam 23 made of the polycrystalline silicon film 106 passes like a beam. That is, in the gap 126, the silicon beam 23 is exposed. In contrast, the trenches 111 arranged in the X direction remain to be separated from each other by the TEOS/O₃ film 110 and the silicon oxide film 107. Hence, the gaps 126 arranged in the X direction are not in communication, but partitioned from each other. The gap 126 serves as a template for forming a gate electrode film 21 in a later process.

In this embodiment, wet etching is used to etch the silicon oxide film 107 and the TEOS/O₃ film 110. However, alternatively, it is also possible to use, for example, CDE (chemical dry etching), or gas etching in which a fluorine-based gas and an ammonia-based gas are used to produce ammonium silicofluoride to etch silicon oxide (SiO₂).

Next, as shown in FIGS. 1 to 5, by heat treatment in an oxidizing atmosphere, the exposed surface of the silicon beam 23 is thermally oxidized to form a silicon oxide layer 24a. Next, by CVD, silicon nitride and silicon oxide are successively deposited on the inner surface of the gap 126 to form a silicon nitride layer 24b and a silicon oxide layer 24c. Thus, the silicon oxide layer 24a, the silicon nitride layer 24b, and the silicon oxide layer 24c are stacked in this order on the exposed surface of the silicon beam 23 so that an ONO film 24 is formed around the silicon beam 23. The ONO film 24 has a total thickness of e.g. 10 nm.

Next, a conductive material, such as polycrystalline silicon, is filled inside the gap 126, that is, in the space surrounded by the remaining silicon oxide films 107, the TEOS/O₃ films 110, and the silicon beams 23 to form a gate electrode film 21. Here, instead of polycrystalline silicon, a metal or an alloy may be filled. The gate electrode film 21 is formed using the gap 126 as a template. Hence, the gate electrode film 21 is shaped like a lattice spreading in the YZ plane and having through holes which the silicon beams 23 pass through. Consequently, a MONOS cell of the stacked SGT type is formed.

Next, interlayer dielectric films, interconnects, contact plugs, via plugs and the like are formed. Thus, a semiconductor memory as shown in FIGS. 1 to 6 is fabricated. Here, the remaining portion of the silicon oxide film 107 and the TEOS/O₃ film 110 constitutes the silicon oxide film 31 shown in FIG. 1 and other figures.

Next, the effect of this embodiment is described.

According to this embodiment, the semiconductor memory according to the above first embodiment can be fabricated. Here, in this semiconductor memory, the bit density of memory cells can be increased by three-dimensionally stacking the memory cells without downscaling the structure. Hence, leading-edge techniques such as EUV (extreme ultraviolet) lithography and immersion ArF lithography are not required. Consequently, the manufacturing cost of the semiconductor memory can be reduced.

Furthermore, in this embodiment, the silicon beams constituting active areas (AA) and gate electrode films constituting gate conductors (GC) can each be formed by one lithography step like the planar NAND flash memory. Thus, only one processing step is needed despite increasing the number of stacked layers, and hence the manufacturing cost does not increase with the increase of the number of stacked layers.

Furthermore, according to this embodiment, the gate electrode film 21 is formed after the silicon beam 23 is formed. Hence, the gate electrode film can be formed from a metal or an alloy. Thus, a metal gate electrode can be realized, and the thickness and spacing of the gate electrode films can be downscaled. Hence, the storage density can be further improved.

In this embodiment, polycrystalline silicon films and silicon oxide films are stacked and simultaneously processed. However, alternatively, single crystal silicon films and silicon oxide films can be stacked and simultaneously processed. Methods for forming a single crystal silicon film illustratively include the method of forming an epitaxial silicon film at high temperature using part of the substrate as a seed, and the method of forming an amorphous silicon film followed by advancing lateral epitaxial growth using part of the substrate as a seed to form an epitaxial silicon film. Furthermore, an amorphous silicon film may be formed instead of the polycrystalline silicon film. Moreover, these silicon films may be previously doped with impurity, or doped with impurity by solid-phase diffusion or other methods after formation.

Next, a third embodiment of the invention is described.

This embodiment relates to a second method for manufacturing the semiconductor memory according to the above first embodiment. This embodiment illustratively manufactures an 8-layer multilayer memory realizing a cell area of 450 nm², which corresponds to the 0X nm generation in the conventional planar NAND flash memory. In this embodiment, the silicon beams constituting active areas (AA) are formed from epitaxial silicon.

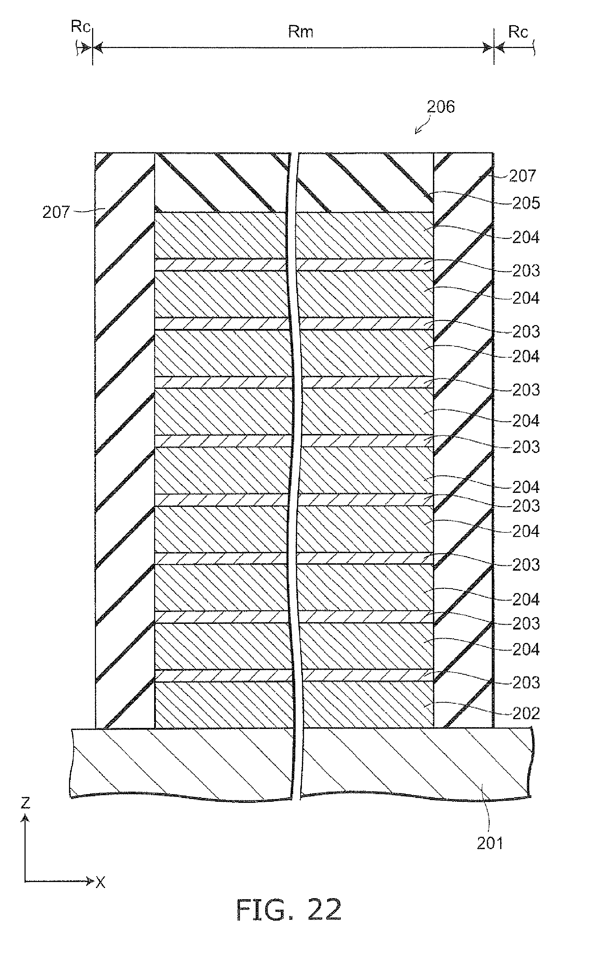

FIG. 22 is a process cross-sectional view illustrating the method for manufacturing a semiconductor memory according to this embodiment.

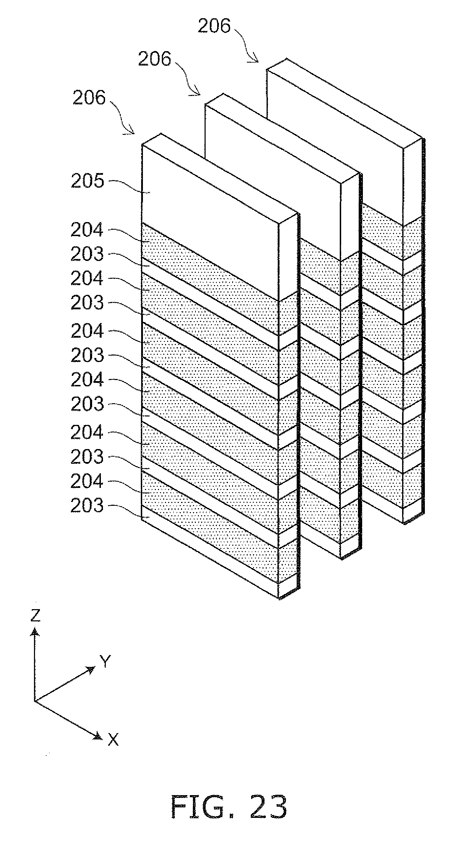

FIGS. 23 to 27 are perspective cross-sectional views illustrating the method for manufacturing a semiconductor memory according to this embodiment.

In FIGS. 23 to 27, for simplicity of illustration, only six layers from the upper layer side of the multilayer body are shown.

First, as shown in FIG. 22, silicon germanium is epitaxially grown on a silicon substrate 201 to a thickness of e.g. 100 nm to form an epitaxial silicon germanium film (epi-SiGe film) 202. Next, silicon and silicon germanium are alternately epitaxially grown on this epi-SiGe film 202 so that epitaxial silicon films (epi-Si films) 203 having a thickness of e.g. 20 nm and a conductivity type of e.g. n-type, and epitaxial silicon germanium films (epi-SiGe films) 204 having a thickness of e.g. 40 nm are alternately stacked, illustratively eight layers each. Next, a silicon nitride film 205 having a thickness of e.g. 100 nm is formed. Thus, on the silicon substrate 201, a multilayer body 206 is formed, which is composed of the epi-SiGe film 202, the eight epi-Si films 203, the eight epi-SiGe films 204, and the silicon nitride film 205.

Next, the conventional lithography technique and reactive ion etching are used to simultaneously process the multilayer body 206 so that the multilayer body 206 is removed from the peripheral circuit region Rc and left only in the memory region Rm.

Next, by plasma CVD, a silicon oxide film 207 having a thickness of e.g. 200 nm is formed. Then, by the lithography technique, the silicon oxide film 207 is left only on the side surface of both X-direction end portions of the multilayer body 206 to form a sidewall. This silicon oxide film 207 serves as a support for the epi-Si films 203 in the multilayer body 206 in a later process.

Next, by the method similar to the above second embodiment (see FIGS. 14 to 16), gate electrode members 33 and the like are formed at one X-direction end portion of the multilayer body 207. Next, by the method similar to the above second embodiment (see FIG. 17), a pattern of a CVD-C film is formed, a sidewall is formed by silicon oxide film formation and RIE leaving the sidewall, and the CVD-C film is removed by ashing. Thus, a hard mask as in the first embodiment is formed, that is, the hard mask (not shown) made of silicon oxide, shaped like stripes extending in the X direction, and having an arrangement pitch of e.g. 60 nm and a width of e.g. 15 nm in the Y direction.

Next, as shown in FIG. 23, the aforementioned hard mask is used as a mask to perform etching so that the multilayer body 206 is simultaneously processed into a banded pattern. Thus, the multilayer body 206 is divided in the Y direction into a plurality of plate-like portions spreading in the XZ direction. Consequently, in each plate-like portion, a plurality of silicon beams 23 are formed, which are made of the divided epi-Si films 203 and extend in the X direction. The shape and dimensions of the silicon beam 23 are illustratively the same as those in the above second embodiment. However, in this embodiment, in contrast to the second embodiment, the epi-Si films 203 are stacked through the intermediary of the epi-SiGe film 204, and hence processing by RIE is relatively easy.

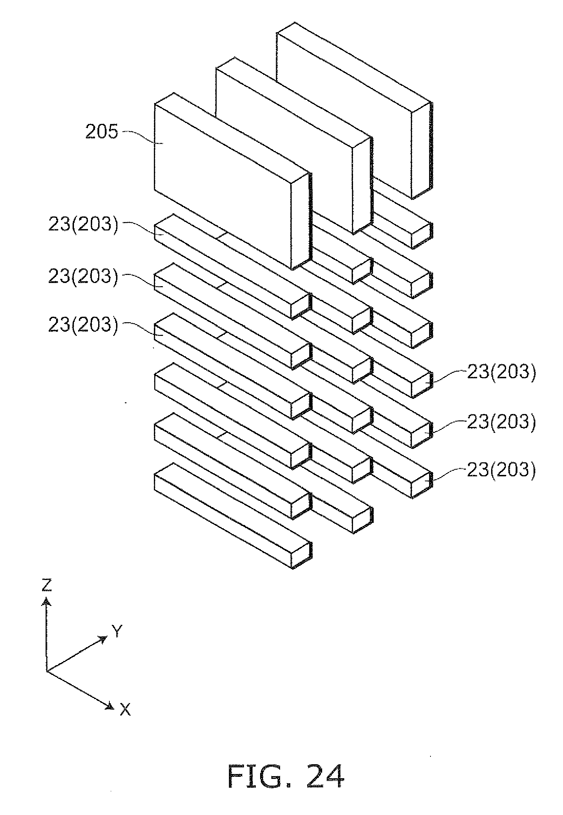

Next, as shown in FIG. 24, the multilayer body 206 is selectively etched to remove the epi-SiGe films 202 and 204. This selective etching can be performed illustratively by wet etching using an aqueous solution etchant in which nitric acid, hydrofluoric acid, and acetic acid are mixed, or CDE using a CF₄-based etching gas. Thus, the silicon beam 23 made of the epi-Si film 203 is exposed. Here, both end portions of each silicon beam 23 are supported by the silicon oxide film 207.

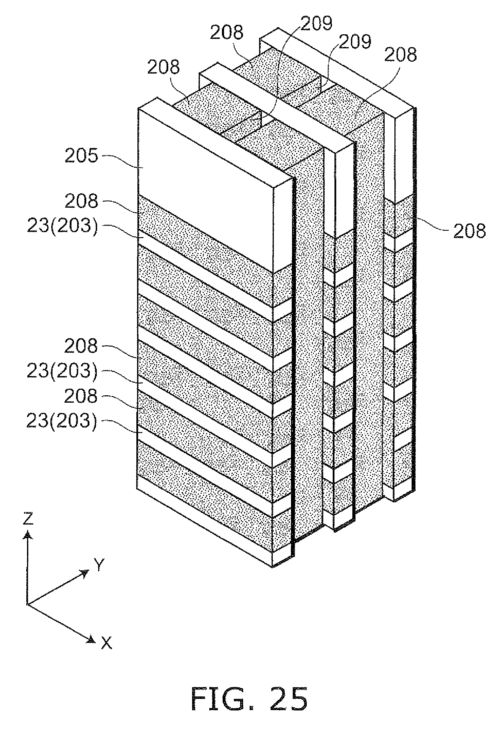

Next, as shown in FIG. 25, in the space between the silicon beams 23 formed by removing the epi-SiGe films 202 and 204, an SOG (spin on glass) film 208 is filled as a dielectric body, and planarized by CMP using the silicon nitride film 205 as a stopper.

Next, by the method similar to the above second embodiment (see FIG. 20), a plurality of trenches 209 are formed in the portion of the SOG film 208 between the silicon beams 23 arranged in the Y direction. The trenches 209 are periodically arranged in the X direction, having an arrangement pitch of e.g. 60 nm and a width of e.g. 20 nm in the X direction.

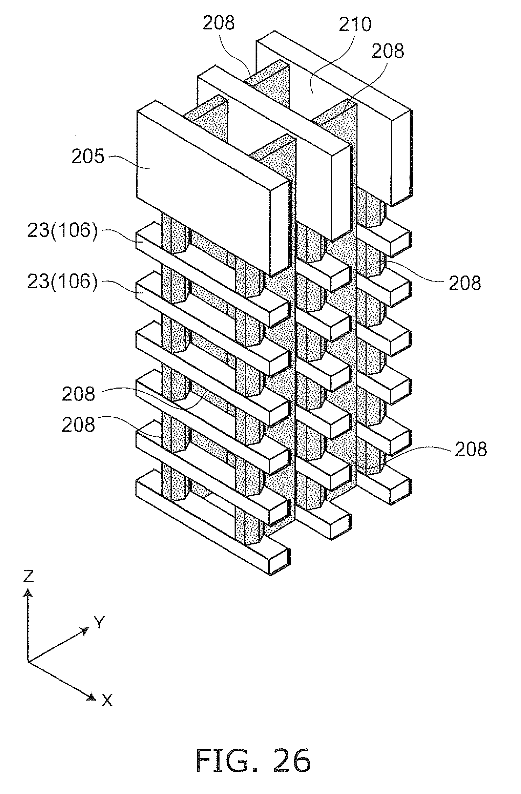

Next, as shown in FIG. 26, wet etching is performed. Thus, through the trenches 209, the SOG film 208 is etched. Here, the etching amount is illustratively as much as 10 nm. Thus, because the X-direction thickness of the SOG film 208 between the silicon beams 23 arranged in the Y direction is 40 nm before etching, it becomes 20 nm after etching. On the other hand, the thickness of the portion of the SOG film 208 located between the silicon beams 23 arranged in the Z direction and sandwiched between the trenches 209, that is, its Y-direction length, is 15 nm before etching. Hence, this portion is completely removed by etching by as much as 10 nm from both sides, and a through hole is formed.

Consequently, the trenches 209 arranged in the Y direction all communicate with each other to form a single gap 210 spreading in the YZ plane. In the gap 210, the silicon beam 23 made of the epi-Si film 203 passes. That is, in the gap 210, the silicon beam 23 is exposed. In contrast, the trenches 209 arranged in the X direction remain to be separated from each other by the remaining SOG film 208. Hence, the gaps 210 arranged in the X direction are not in communication, but partitioned from each other. The gap 210 serves as a template for forming a gate electrode film 21 in a later process.

In this embodiment, wet etching is used to etch the SOG film 208 to form a gap 210 serving as a template for the gate electrode film. However, alternatively, it is also possible to use, for example, CDE, or gas etching in which a fluorine-based gas and an ammonia-based gas are used to produce ammonium silicofluoride to etch silicon oxide (SiO₂).

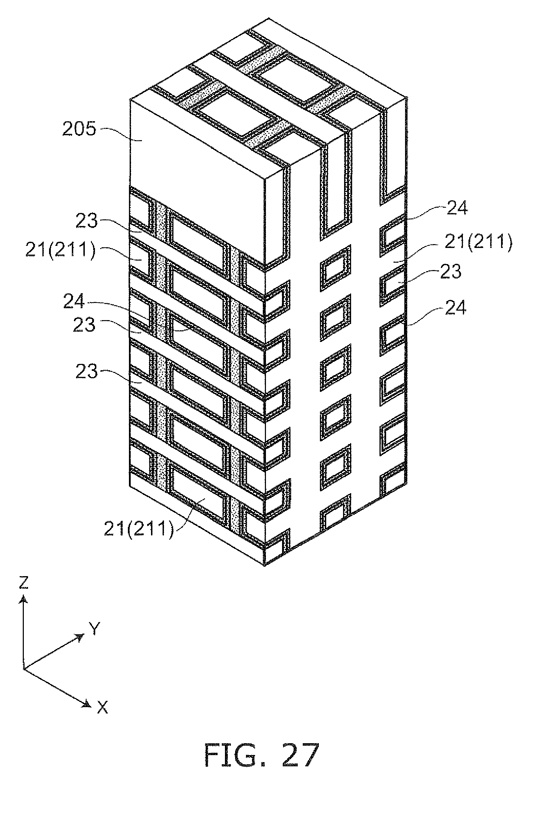

Next, as shown in FIG. 27, a silicon oxide layer is formed by thermally oxidizing the surface of the silicon beam 23 exposed by the processing, a silicon nitride layer is formed by CVD, and an alumina (Al₂O₃) layer is formed by ALD. Thus, an ONO film 24 having a total thickness of e.g. 10 nm is formed on the exposed surface of the silicon beam 23. Next, a conductive material, tungsten nitride (WN), is filled in the gap 210, that is, in the space surrounded by the remaining SOG films 208 and the silicon beams 23 with the ONO film 24 formed therearound to form a gate electrode film 21 made of a WN film 211. The subsequent process is similar to that of the above second embodiment. Thus, the semiconductor memory according to the above first embodiment is manufactured.

Next, the effect of this embodiment is described.

Also according to this embodiment, the semiconductor memory according to the above first embodiment can be fabricated. Furthermore, according to this embodiment, in comparison with the above second embodiment, the epi-Si film 203 constituting the silicon beam 23 can be formed by epitaxial growth. Hence, the silicon beam 23 can be formed from single crystal silicon having good crystallinity. Thus, the active area (AA) has good characteristics. Furthermore, in the multilayer body 206, the epi-Si films 203 and the epi-SiGe films 204 are stacked, and hence it is easily processed. Thus, the number of stacked layers can be increased.

The semiconductor memory manufactured by this embodiment includes eight silicon beams 23 stacked on the substrate, and hence can achieve higher storage density than the planar NAND flash memory. More specifically, the semiconductor memory manufactured by this embodiment has an effective cell area of 3600/8 = 450 nm². On the other hand, to achieve an effective cell area equivalent thereto, the semiconductor memory according to the above comparative example requires stacking 16.33 layers. The yield of the multilayer structure is the product of the yields of the layers therein. Hence, this embodiment can achieve high yield. The effect of this embodiment other than the foregoing is the same as that of the above second embodiment.

Next, a fourth embodiment of the invention is described.

This embodiment relates to a third method for manufacturing the semiconductor memory according to the above first embodiment. This embodiment illustratively manufactures a 16-layer multilayer memory realizing a cell area of 225 nm², which corresponds to the 00X nm generation in the conventional planar NAND flash memory. In this embodiment, the silicon beam constituting active areas (AA) is formed from epitaxial silicon, and the dielectric film between the AAs is formed from a thermal oxide film.

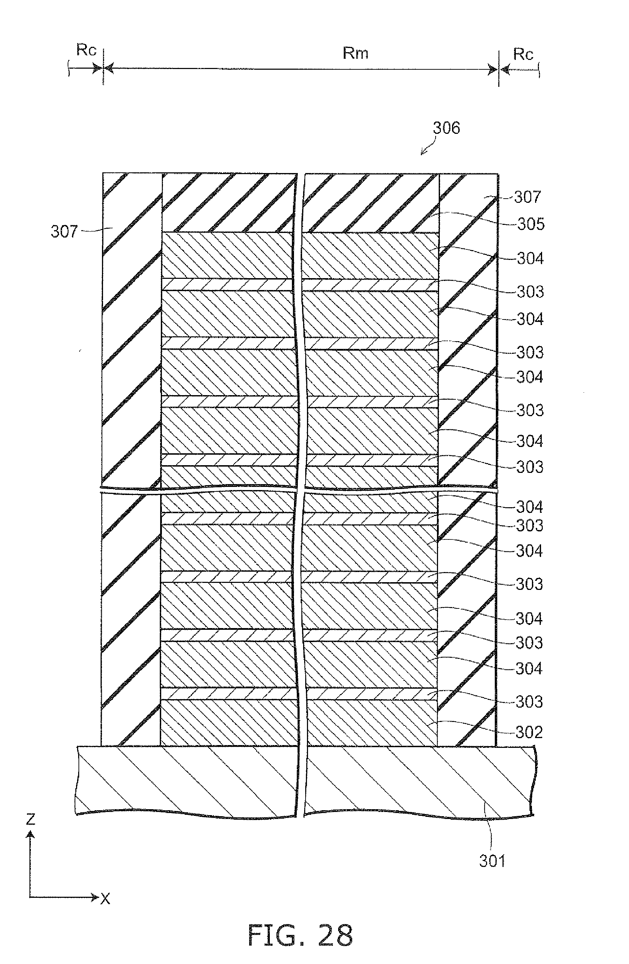

FIG. 28 is a process cross-sectional view illustrating the method for manufacturing a semiconductor memory according to this embodiment.

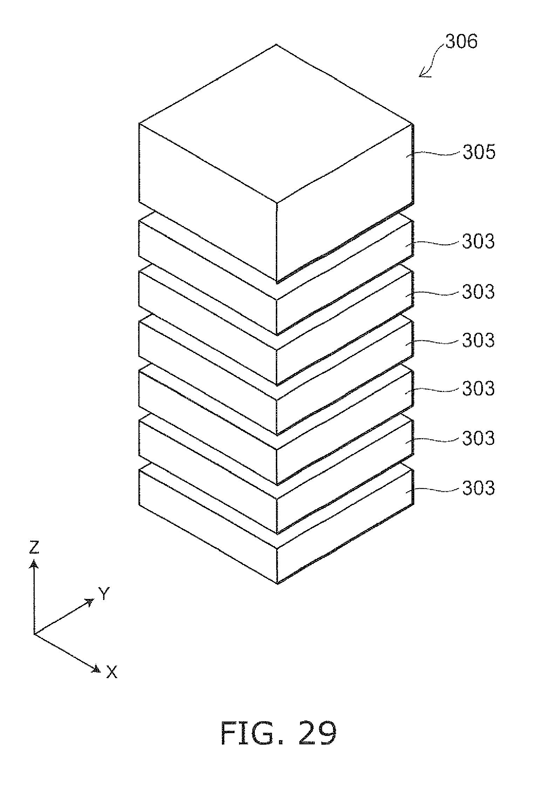

FIGS. 29 to 32 are perspective cross-sectional views illustrating the method for manufacturing a semiconductor memory according to this embodiment.

In FIGS. 29 to 32, for simplicity of illustration, only six layers from the upper layer side of the multilayer body are shown.

First, by the method similar to the above third embodiment (see FIG. 22), a multilayer body composed of epitaxial silicon films and epitaxial silicon germanium films is formed on a silicon substrate 301. However, although the number of stacked layers is eight in the above third embodiment, the number of stacked layers is 16 in this embodiment.

Specifically, as shown in FIG. 28, silicon germanium is epitaxially grown on the silicon substrate 301 to a thickness of e.g. 100 nm to form an epitaxial silicon germanium film (epi-SiGe film) 302. Next, silicon and silicon germanium are alternately epitaxially grown on this epi-SiGe film 302 so that epitaxial silicon films (epi-Si films) 303 having a thickness of e.g. 45 nm and a conductivity type of e.g. n-type, and epitaxial silicon germanium films (epi-SiGe films) 304 having a thickness of e.g. 20 nm are alternately stacked, illustratively 16 layers each. Next, a silicon nitride film 305 having a thickness of e.g. 100 nm is formed. Thus, on the silicon substrate 301, a multilayer body 306 is formed, which is composed of the epi-SiGe film 302, the 16 epi-Si films 303, the 16 epi-SiGe films 304, and the silicon nitride film 305.

Next, the conventional lithography technique and reactive ion etching are used to simultaneously process the multilayer body 306 so that the multilayer body 306 is removed from the peripheral circuit region Rc and left only in the memory region Rm.

Next, by plasma CVD, a silicon oxide film 307 having a thickness of e.g. 200 nm is formed. Then, by the lithography technique, the silicon oxide film 307 is left only on the side surface of both end portions in one direction of the multilayer body 306, such as both X-direction end portions. Thus, a sidewall for supporting the multilayer body 306 is formed on a pair of side surfaces of the multilayer body 306.

Next, as shown in FIG. 29, by the method similar to the above third embodiment, selective etching is performed on the exposed side surface of the multilayer body 306, that is, the side surface of both end portions in the Y direction, to remove the epi-SiGe films 302 and 304 (see FIG. 28). Here, both X-direction end portions of each epi-Si film 303 are supported by the side wall bracings made of the silicon oxide film 307 (see FIG. 28).

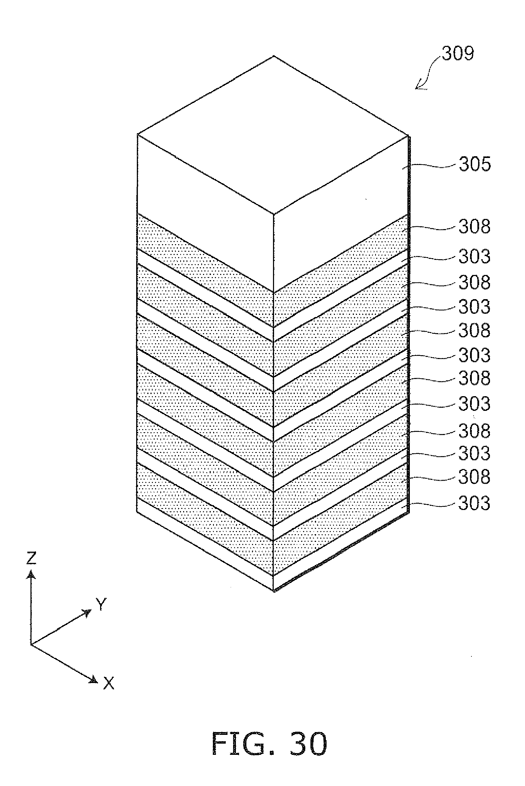

Next, as shown in FIG. 30, by steam oxidation, the epi-Si film 303 is oxidized from both upper and lower surface side. Thus, a silicon thermal oxide film 308 is formed between the epi-Si films 303, and the gap formed by removing the epi-SiGe films 302 and 304 is filled with the silicon thermal oxide film 308. Consequently, a multilayer body 309 is formed, in which the epi-Si films 303 and the silicon thermal oxide films 308 are alternately stacked. Here, the thickness of the epi-Si film 303 is decreased to approximately 20 nm by oxidation from both sides.

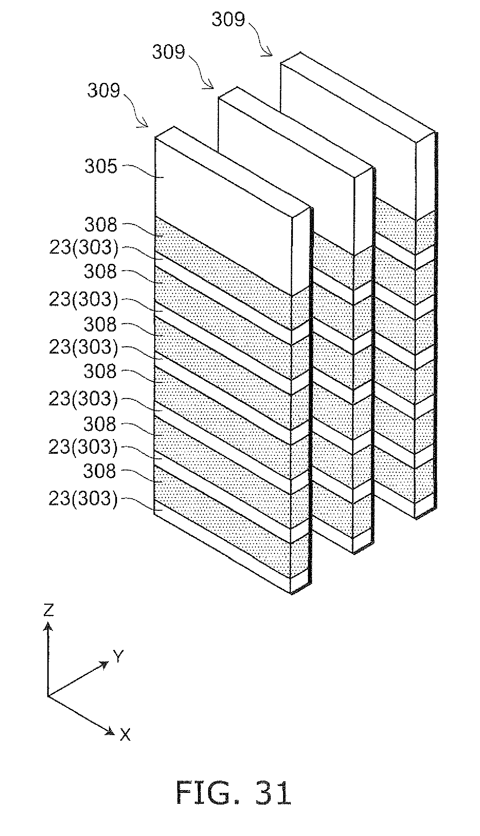

The subsequent process is similar to that of the above second embodiment. More specifically, as shown in FIG. 31, by the conventional ArF lithography technique, RIE technique, and sidewall transfer technique, a hard mask (not shown) shaped like stripes extending in the X direction and having an arrangement pitch of 60 nm and a width of 15 nm in the Y direction is formed, and used to simultaneously process the multilayer body 309 into a banded pattern serving as the AA region of the multilayer memory. Thus, a plurality of silicon beams 23 extending in the X direction are formed from the divided epi-Si films 303.

Next, a TEOS/O₃ film is filled between the multilayer bodies 309 divided into a banded pattern, and the upper surface is planarized by CMP. Next, by the ArF lithography technique, RIE technique, and sidewall transfer technique, a hard mask (not shown) extending in the Y direction and having an arrangement pitch of 60 nm and a width of 15 nm in the X direction is formed. Then, this hard mask is used to perform etching to form trenches in the TEOS/O₃ film. Consequently, TEOS/O₃ films are formed discontinuously in the X direction between the divided multilayer bodies 309.

Next, by gas etching using NF₃ plasma and ammonia, the silicon thermal oxide film 308 is etched from both sides in the Y direction through these trenches. Here, the etching amount is illustratively as much as 15 nm. Thus, because the portion of the silicon thermal oxide film 308 sandwiched between the trenches has a Y-direction width of 15 nm before etching, it is completely removed by etching, and a through hole is formed. On the other hand, gas etching using NF₃ plasma and ammonia can achieve non-selective etching for the silicon thermal oxide film 308 and the TEOS/O₃ film. Hence, the TEOS/O₃ film is also etched from both sides in the X direction by 15 nm each. Because the TEOS/O₃ film has an X-direction thickness of 45 nm before etching, it has a thickness of 15 nm after etching, and is left. Consequently, like the above second embodiment, the trenches arranged in the Y direction communicate with each other to form a gap serving as a template for the gate electrode film 21.

Next, the exposed surface of the silicon beam 23 made of the epi-Si film 303 is thermally oxidized to form a silicon oxide layer serving as a tunnel layer. Next, a silicon nitride layer serving as a charge storage layer is formed by CVD. Next, an HfO₂ layer serving as a block layer is formed by ALD. Thus, an ONO film 24 having a total thickness of e.g. 10 nm is formed around the silicon beam 23.

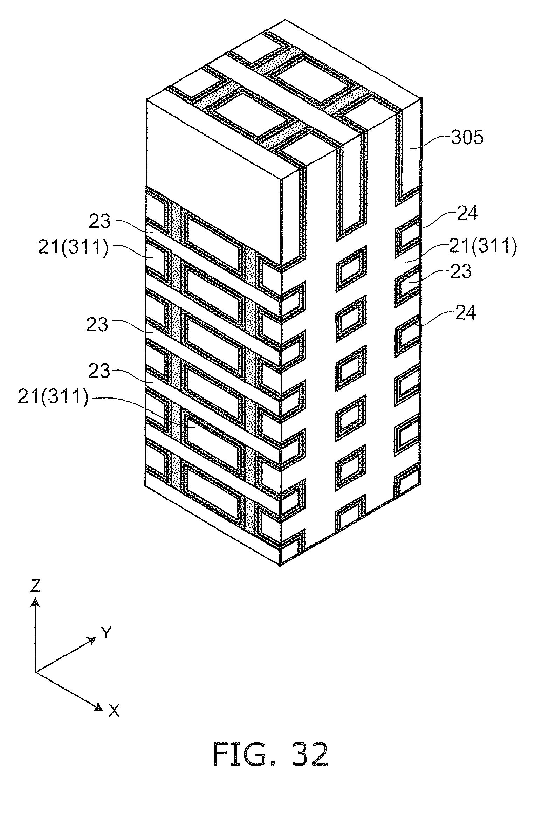

Next, as shown in FIG. 32, a conductive material, tantalum nitride (TaN), is deposited by ALD in the gap formed by etching, that is, in the space surrounded by the remaining silicon thermal oxide films 308, the remaining TEOS/O₃ films, and the silicon beams 23. Thus, a gate electrode film 21 made of a TaN film 311 is filled in this gap. Consequently, a MONOS cell of the stacked SGT type is formed. The subsequent process is similar to that of the above second embodiment. Thus, the semiconductor memory according to the above first embodiment is manufactured.

Next, the effect of this embodiment is described.

Also according to this embodiment, the semiconductor memory according to the above first embodiment can be fabricated. Furthermore, according to this embodiment, in comparison with the above second embodiment, the epi-Si film 303 constituting the silicon beam 23 can be formed by epitaxial growth. Hence, the silicon beam 23 can be formed from single crystal silicon having good crystallinity. Thus, the active area (AA) has good characteristics. Furthermore, according to this embodiment, the dielectric film provided between the silicon beams can be formed from a thermal oxide film, achieving robustness and reliability. Thus, the number of stacked layers can be increased.

The semiconductor memory manufactured by this embodiment includes 16 silicon beams 23 stacked on the substrate, and hence can achieve 16 times higher storage density than the planar NAND flash memory. More specifically, the semiconductor memory manufactured by this embodiment has an effective cell area of 3600/16 = 225 nm². On the other hand, to achieve an effective cell area equivalent thereto, the semiconductor memory according to the above comparative example requires stacking 32.67 layers. The yield of the multilayer structure is the product of the yields of the layers therein. Hence, this embodiment can achieve high yield. The effect of this embodiment other than the foregoing is the same as that of the above second embodiment.

Thus, the above embodiments can realize a semiconductor memory allowing smaller cells to be formed, allowing a metal gate to be easily used, and requiring no substantial change to the peripheral circuit of the conventional planar NAND flash memory, without impairing the feature of reducing the manufacturing cost per bit with the increase of the number of stacked layers and the feature of being able to construct high-performance SGT cells. According to the above embodiments, for the memory having the structure as shown in FIGS. 7 to 11, the cell area can be reduced approximately by half, that is, the number of stacked layers can be reduced approximately by half. Hence, memory layers can be stacked without significantly increasing process steps. Thus, it is possible also in the future to continue increasing the bit density of semiconductor memories, particularly flash memories, and to further expand application areas of flash memories.

The invention has been described with reference to the embodiments. However, the invention is not limited to these embodiments. For example, the above embodiments can be practiced in combination with each other. Furthermore, those skilled in the art can suitably modify the above embodiments by addition, deletion, or design change of components, or by addition, omission, or condition change of processes, and such modifications are also encompassed within the scope of the invention as long as they fall within the spirit of the invention.

For example, the method for forming a silicon film constituting AA, the film structure of the MONOS and the like illustrated in the above embodiments are not limited to the combination illustrated in the above embodiments, but any combination is possible as long as it does not violate the spirit of the invention. Furthermore, the silicon film constituting AA can be made of a polycrystalline silicon film or single crystal silicon film crystallized by methods not described in the above embodiments, such as laser annealing or the Ni catalyst process. Furthermore, the block layer of the MONOS is illustratively made of SiO₂, Al₂O₃, or HfO₂ in the above embodiments. However, in addition, it is also possible to use La₂O₃, Pr₂O₃, Y₂O₃, ZrO₂ and other metal oxide films, or a film based on a combination of more than one of the above metal oxide films. Moreover, the gate electrode film is illustratively made of polycrystalline silicon, tungsten nitride (WN), or tantalum nitride (TaN) in the above embodiments. However, in addition, the gate electrode film can be made of materials such as TiN, W, WSi, CoSi, NiSi, PrSi, NiPtSi, PtSi, Pt, Ru, and RuO₂. Moreover, the number of stacked layers is 4, 8, or 16 in the above embodiments. However, the invention is also applicable to semiconductor memories including more layers. Moreover, silicon is used as the semiconductor material for forming AA in the above embodiments. However, the invention is not limited thereto, but other semiconductor materials may be used.

### Industrial applicability

According to the invention, a semiconductor memory capable of increasing bit density by three-dimensional arrangement of cells, and a method for manufacturing the same can be realized.

## Claims

1. A semiconductor memory comprising:
a substrate;
a plurality of gate electrode films provided on the substrate, arranged along one direction parallel to an upper surface of the substrate, and including a plurality of through holes as viewed in the one direction;
a plurality of semiconductor beams extending in the one direction through the through holes of the plurality of gate electrode films; and
a charge storage layer provided between the gate electrode film and the semiconductor beam.

2. The semiconductor memory according to claim 1, further comprising:
a dielectric film provided between the gate electrode films,
wherein the gate electrode films are equally spaced.

3. The semiconductor memory according to claim 1, wherein the plurality of through holes are arranged in a matrix as viewed in the one direction.

4. The semiconductor memory according to claim 1, wherein one of the semiconductor beams is inserted through one of the through holes.

5. The semiconductor memory according to claim 1, wherein the gate electrode film is formed from silicon, tungsten nitride, or tantalum nitride.

6. The semiconductor memory according to claim 1, further comprising:
a first silicon oxide layer provided between the semiconductor beam and the charge storage layer; and
a second silicon oxide layer provided between the charge storage layer and the gate dielectric film,
wherein the charge storage layer is formed from silicon nitride.

7. The semiconductor memory according to claim 1, further comprising:
a plurality of gate electrode members extending in another direction parallel to the upper surface of the substrate and orthogonal to the one direction; and
a gate dielectric film provided between the semiconductor beam and the gate electrode members,
wherein in a structure composed of the plurality of gate electrode films, the plurality of semiconductor beams, and the charge storage layer, an end portion in the one direction is processed into a staircase pattern, the number of stairs is equal to the number of the semiconductor beams arranged in a direction perpendicular to the upper surface of the substrate, and the gate electrode members are placed above the respective stairs of the structure.

8. The semiconductor memory according to claim 7, further comprising:
a plurality of transistors placed on the one direction side of the structure, the number of the transistors being equal to the number of the semiconductor beams arranged in the other direction, and commonly connected to the plurality of semiconductor beams arranged in the direction perpendicular to the upper surface of the substrate.

9. A method for manufacturing a semiconductor memory, comprising:
forming a multilayer body by alternately stacking a plurality of dielectric films and semiconductor films on a substrate;
dividing the multilayer body in a first direction parallel to an upper surface of the substrate to form a plurality of semiconductor beams made of the divided semiconductor films and extending in a second direction parallel to the upper surface of the substrate and orthogonal to the first direction;
providing dielectric bodies between the divided multilayer bodies discontinuously in the second direction;
performing etching through a gap surrounded by the divided multilayer bodies and the dielectric bodies to remove a portion of the dielectric films sandwiched between the gaps;
forming a charge storage layer on an exposed surface of the semiconductor beams; and
filling a conductive material in a space among remaining portions of the dielectric films, the dielectric bodies, and the semiconductor beams to form a gate electrode film.

10. The method for manufacturing a semiconductor memory according to claim 9, wherein the semiconductor film is formed from silicon.

11. The method for manufacturing a semiconductor memory according to claim 10, further comprising:
after the removing a portion of the dielectric films sandwiched between the gaps, forming a first silicon oxide layer on an exposed surface of the semiconductor beam by heat treatment in an oxidizing atmosphere; and
forming a second silicon oxide layer on the charge storage layer by depositing silicon oxide,
wherein the forming the charge storage layer includes depositing silicon nitride.

12. The method for manufacturing a semiconductor memory according to claim 9, wherein the providing the dielectric bodies discontinuously includes:
filling the dielectric bodies between the divided multilayer bodies;
forming a pattern of stripes extending in the first direction on the multilayer bodies and the dielectric bodies; and
performing dry etching using the pattern as a mask.

13. A method for manufacturing a semiconductor memory, comprising:
forming a multilayer body by alternately epitaxially growing a plurality of silicon germanium films and silicon films on a substrate;
dividing the multilayer body in a first direction parallel to an upper surface of the substrate to form a plurality of silicon beams made of the divided silicon films and extending in a second direction parallel to the upper surface of the substrate and orthogonal to the first direction;
removing the silicon germanium films to expose the silicon beams;
filling dielectric bodies between the silicon beams;
forming a plurality of trenches arranged in the second direction in a portion of the dielectric bodies between the silicon beams arranged in the first direction;
removing a portion of the dielectric bodies sandwiched between the trenches and sandwiched between the vertically arranged silicon beams by performing etching through the trenches;
forming a charge storage layer on an exposed surface of the silicon beams; and
forming a gate electrode film by filling a conductive material in a space among remaining portions of the dielectric bodies and the silicon beams.

14. The method for manufacturing a semiconductor memory according to claim 13, further comprising:
forming a sidewall bracing on a side surface of both end portions in the second direction of the multilayer body.

15. The method for manufacturing a semiconductor memory according to claim 13, further comprising:
after the removing a portion of the dielectric sandwiched between the trenches, forming a silicon oxide layer on an exposed surface of the semiconductor beam by heat treatment in an oxidizing atmosphere; and
forming an alumina layer on the charge storage layer,
wherein the forming the charge storage layer includes depositing silicon nitride.

16. The method for manufacturing a semiconductor memory according to claim 13, wherein the forming the gate electrode film uses tungsten nitride as the conductive material.

17. A method for manufacturing a semiconductor memory, comprising:
forming a first multilayer body by alternately epitaxially growing a plurality of silicon germanium films and silicon films on a substrate;
removing the silicon germanium films;
forming a second multilayer body with the silicon films and silicon thermal oxide films alternately stacked, by thermally oxidizing the silicon films to form the silicon thermal oxide film between the silicon films;
dividing the second multilayer body in a first direction parallel to an upper surface of the substrate to form a plurality of silicon beams made of the divided silicon films and extending in a second direction parallel to the upper surface of the substrate and orthogonal to the first direction;
providing dielectric bodies between the divided second multilayer bodies discontinuously in the second direction;
performing etching through a gap surrounded by the divided second multilayer bodies and the dielectric bodies to remove a portion of the silicon thermal oxide films sandwiched between the gaps;
forming a charge storage layer on an exposed surface of the silicon beams; and
forming a gate electrode film by filling a conductive material in a space among remaining portions of the silicon thermal oxide films, the dielectric bodies, and the silicon beams.

18. The method for manufacturing a semiconductor memory according to claim 17, further comprising:
forming a sidewall bracing on a side surface of both end portions in the first direction or both end portions in the second direction of the first multilayer body.

19. The method for manufacturing a semiconductor memory according to claim 17, wherein in the forming the second multilayer body, the silicon films are thermally oxidized by steam oxidation.

20. The method for manufacturing a semiconductor memory according to claim 17, wherein the forming the gate electrode film uses tantalum nitride as the conductive material.
